# EUROPEAN PATENT APPLICATION

(11) **EP 1 744 346 A1**
(43) Date of publication of application: **17.01.2007**
(21) Application number: 05027887.8
(22) Date of filing: 20.12.2005
(51) Int. Cl.: H01J 37/34

(54) **Magnetron sputtering system for large-area substrates having removable anodes**

(30) Priority: 13.07.2005 US 699428 P; 11.10.2005 US 247438; 11.10.2005 US 247705
(71) Applicant: APPLIED MATERIALS, INC., Santa Clara, California 95054 (US)
(72) Inventor: Hosokawa, Akihiro, Cupertino, CA 95014 (US); Le, Hien Minh H., San Jose, CA 95148 (US); Inagawa, Makoto, Palo Alto, CA 94306 (US); White, John M., Hayward, CA 94541 (US)
(74) Representative: Zimmermann, Gerd Heinrich

(57) **Abstract**

The present invention generally provides an apparatus and method for processing a surface of a substrate in physical vapor deposition (PVD) chamber that has an increased anode surface area to improve the deposition uniformity on large area substrates. In general, aspects of the present invention can be used for flat panel display processing, semiconductor processing, solar cell processing, or any other substrate processing. In one aspect, the processing chamber contains one or more anode assemblies that are used to increase and more evenly distribute the anode surface area throughout the processing region of the processing chamber. In one aspect, the anode assembly contains a conductive member and conductive member support. In one aspect, the processing chamber is adapted to allow the conductive member to be removed from the processing chamber without removing any major components from the processing chamber.

## Description

### BACKGROUND OF THE INVENTION

Embodiments of the present invention generally relate to substrate plasma processing apparatuses and methods that are adapted to deposit a film on a surface of a substrate.

Physical vapor deposition (PVD) using a magnetron is one of the principal methods of depositing metal onto a semiconductor integrated circuit to form electrical connections and other structures in an integrated circuit device. During a PVD process a target is electrically biased so that ions generated in a process region can bombard the target surface with sufficient energy to dislodged atoms from the target. The process of biasing a target to cause the generation of a plasma that causes ions to bombard and remove atoms from the target surface is commonly called sputtering. The sputtered atoms travel generally towards the wafer being sputter coated, and the sputtered atoms are deposited on the wafer. Alternatively, the atoms react with another gas in the plasma, for example, nitrogen, to reactively deposit a compound on the wafer. Reactive sputtering is often used to form thin barrier and nucleation layers of titanium nitride or tantalum nitride on the sides of narrow holes.

DC magnetron sputtering is the most usually practiced commercial form of sputtering. The PVD target is biased to a negative DC bias in the range of about -100 to -600 VDC to attract positive ions of the working gas (e.g., argon) toward the target to sputter the metal atoms. Usually, the sides of the sputter reactor are covered with a shield to protect the chamber walls from sputter deposition. The shield is typically electrically grounded and thus provides an anode in opposition to the target cathode to capacitively couple the DC target power into the chamber and its plasma.

A magnetron having at least a pair of opposed magnetic poles is typically disposed near the back of the target to generate a magnetic field close to and parallel to the front face of the target. The induced magnetic field from the pair of opposing magnets trap electrons and extend the electron lifetime before they are lost to an anodic surface or recombine with gas atoms in the plasma. Due to the extended lifetime, and the need to maintain charge neutrality in the plasma, additional argon ions are attracted into the region adjacent to the magnetron to form there a high-density plasma. Thereby, the sputtering rate is increased.

However, conventional sputtering presents challenges in the formation of advanced integrated circuits on large area substrates, such as flat panel display substrates. Typically, for TFT applications, the substrate is a glass substrate with a surface area greater than about 2000 cm². Commonly, TFT processing equipment is generally configured to accommodate substrates up to about 1.5 x 1.8 meters. However, processing equipment configured to accommodate substrate sizes up to and exceeding 2.16 x 2.46 meters, is envisioned in the immediate future. One issue that arises is that it is generally not feasible to create a chamber big enough to maintain the surface area ratio of the cathode (target) to anode surface area commonly used in conventional sputter processing chambers. Trying to maintain the surface area ratio can lead to manufacturing difficulties due to the large size of the parts required to achieve the desired area ratio and processing problems related to the need to pump down such a large volume to a desired base pressure prior to processing. The reduced surface area of the anode relative to the large target surface area generally causes the density of the plasma generated in the processing region, which is generally defined as the region below the target and above the substrate, to vary significantly from the center of the target to the edge of the target. Since the anodic surfaces are commonly distributed around the periphery of the target, it is believed that the larger distance from the center of the target to the anodic surfaces, makes the emission of electrons from the target surface at the edge of the target more favorable, and thus reduces the plasma density near the center of the target. The reduction in plasma density in various regions across the target face will reduce the number of ions striking the surface of the target in that localized area, thus varying the uniformity of the deposited film across the surface of a substrate that is positioned a distance from the target face. The insufficient anode area problem thus manifests itself as a film thickness non-uniformity that is smaller near the center of the substrate relative to the edge.

To resolve the insufficient anode area problem some individuals have installed additional anode structures that are positioned in the processing region below the target to increase the anode surface area. Installed anode structures commonly include a fixed-anode structure (e.g., collimator) or a scanning anode structure that is positioned below the target face, which is aligned with and moves with the moving magnetron structure as it is translated during the deposition process. One problem with the anode structure(s) retained, or installed, in the processing region is that over time the target material is continually deposited on the substrates during processing, thus causing the size and shape of the structures to vary with time. Since PVD type processes are typically line of sight type deposition processes the variation in the size and shape of the structures over time will cause the deposition uniformity to change over time. The deposition of the target material on the structures also increases the probability that the material deposited thereon will crack and flake during processing, due to intrinsic or extrinsic stress formed in the films deposited on these structures. Cracking and flaking of the deposited film can generate particles that can affect the yield of the devices formed using this process.

One issue that arises in the prior art configurations is that they require the removal of major components from the process chamber, such as the target and/or PVD chamber lid (e.g., target, magnetron, shields), to access and remove the installed additional anode structures. This process of removing major components from the process chamber can be costly and time consuming, due to the exposure of the chamber to atmospheric contamination (e.g., water, reactive gases) which will require a significant amount of time to bakeout the PVD chamber before processing can continue. Also, removal of the major chamber components causes the film deposited on shield components from prior PVD process steps to oxidize, or become contaminated, which can thus require their removal and replacement due to particle contamination concerns. Also, the installation of the major components back onto the process chamber can be very time consuming, since they will require the precise alignment of the target to the installed anode surface(s) to prevent arcing and sputtering of undesirable areas of the target.

Therefore, there is a need for a method and apparatus that can increase the anode surface area in a PVD processing chamber to form a more uniform PVD deposited film, where the anode surfaces will not generate a significant number of particles and can be replaced in an efficient and cost effective manner once a significant amount of deposition has been deposited on their surfaces.

### SUMMARY OF THE INVENTION

This and related problems are solved by the plasma processing chamber assembly according to claims 1, 11, 15 and 36, by the anode member according to claim 22, and by the methods according to claims 24, 26, 32, 36.
Further details, improvements and preferred embodiments of the invention are disclosed in the dependent claims, the description and the figures.

The present invention generally provides a plasma processing chamber assembly for depositing a layer on a substrate comprising: a plasma processing chamber having a processing region, a target positioned on the plasma processing chamber so that a surface of the target is in contact with the processing region, a substrate support positioned within the plasma processing chamber and having a substrate receiving surface, wherein a surface of a substrate positioned on the substrate receiving surface is in contact with the processing region, and a plurality of anodic members positioned in the processing region between the target and the substrate support, wherein the plurality of anodic members are in electrical communication with an anodic shield that is in contact with the processing region.

Embodiments of the invention may further provide a plasma processing chamber assembly for uniformly depositing a layer on a rectangular substrate comprising: a plasma processing chamber having a processing region, a target positioned on the plasma processing chamber so that a surface of the target is in contact with the processing region, a substrate support positioned within the plasma processing chamber and having a substrate receiving surface, wherein a surface of a rectangular substrate positioned on the substrate receiving surface is in contact with the processing region, and a plurality of anodic members positioned within the processing region between the target and the substrate support, wherein the plurality of anodic members are in electrical communication with an anodic shield and are aligned in a direction relative to an edge of the rectangular substrate.

Embodiments of the invention may further provide a plasma processing chamber assembly for depositing a layer on a substrate comprising: a chamber body assembly having one or more walls that enclose a vacuum region, wherein the chamber body assembly has one or more access ports formed in at least one of the one or more walls, a target positioned on the chamber body assembly so that a surface of the target faces a processing region formed within the vacuum region, an anodic shield having a surface that contacts the vacuum region, wherein the anodic shield comprises: one or more walls that partially enclose the processing region, and a first slot formed through the one of the one or more walls of the anodic shield, a substrate support positioned within the vacuum region and having a substrate receiving surface, wherein a surface of a substrate positioned on the substrate receiving surface faces the target, and one or more anodic members that comprise: a first member mounted within the processing region, wherein the first member is in electrical communication with the anodic shield and is adapted to be removed from the processing region through the first slot and one of the one or more access ports.

Embodiments of the invention may further provide an anode member positioned in a plasma processing chamber assembly, wherein the anode member comprises: a first member mounted between a target and a substrate positioned on a substrate support, wherein the first member is in electrical communication with an anodic pole of a power supply that is adapted to cathodically bias the target, and a plurality of second members positioned on the first member, wherein the second members are in electrical communication with the first member and are adapted to cover at least a portion of the first member to prevent sputtered material from the target depositing on the first member.

Embodiments of the invention may further provide a method of sputter depositing a layer on a substrate, comprising: depositing a layer on a substrate surface in a sputter deposition chamber that has one or more walls and a target that enclose a processing region and one or more anodic members positioned within the processing region, venting the sputter deposition chamber by injecting a gas into the processing region, and removing one of the one or more anodic members from the processing region through an access hole formed in one of the one or more walls of the sputter deposition chamber.

Embodiments of the invention may further provide a method of enhancing the uniformity of a sputter deposition process on a substrate, comprising: providing a sputter deposition chamber that has one or more walls that form a processing region, a target, and two or more anode assemblies positioned below the target and within the processing region, wherein the two or more anode assemblies are in electrical communication with an anodic surface positioned within the processing region, and depositing a layer on a surface of a substrate positioned in the processing region by cathodically biasing the target relative to the two or more anode assemblies and the anodic surface using a power supply.

Embodiments of the invention may further provide a method of enhancing the uniformity of a sputter deposition process on a substrate, comprising: positioning an anode member in a processing region formed between a target and a processing surface of a substrate positioned on a substrate support, wherein the step of positioning the anode member comprises, positioning a first member in the processing region, wherein the first member is in electrical communication with an anodic shield, and positioning one or more second members on the first member, wherein the one or more second members are in electrical communication with the first member and are adapted to cover at least a portion of the first member to prevent sputtered material from the target depositing on the first member, and depositing a layer on the processing surface by applying a bias between the target and the anodic shield.
The present invention generally further relates to an apparatus and method for processing a surface of a substrate in physical vapor deposition (PVD) chamber that has an increased anode surface area to improve the deposition uniformity on large area substrates. In general, aspects of the present invention can be used for flat panel display processing, semiconductor processing, solar cell processing, or any other substrate processing. In one aspect, the processing chamber contains one or more anode assemblies that are used to increase and more evenly distribute the anode surface area throughout the processing region of the processing chamber. In one aspect, the anode assembly contains a conductive member and conductive member support. In one aspect, the processing chamber is adapted to allow the conductive member to be removed from the processing chamber without removing any major components from the processing chamber.

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

Figure 1 is a vertical cross-sectional view of conventional physical vapor deposition chamber.

Figure 2 is a vertical cross-sectional view of one embodiment of an exemplary physical vapor deposition chamber according to this invention.

Figure 3A is a plan view of a linear magnetron usable with embodiments of the invention.

Figure 3B is a vertical cross-sectional view of one embodiment of a processing region formed in an exemplary physical vapor deposition chamber.

Figure 3C is a schematic plan view of one embodiment of a plasma loop formed by a serpentine magnetron according to one aspect of the invention.

Figure 3D is a schematic plan view of another one embodiment of a plasma loop formed by a rectangularized spiral magnetron according to one aspect of the invention.

Figure 3E is a plan view of a serpentine magnetron according to one aspect of the invention.

Figure 3F is a plan view of a serpentine magnetron according to another aspect of the invention.

Figure 4 is an isometric view of a lower chamber assembly in an exemplary physical vapor deposition chamber.

Figure 5A is an isometric cross-sectional view of an anode assembly formed in an exemplary physical vapor deposition chamber.

Figure 5B is an isometric cross-sectional view of an anode assembly formed in an exemplary physical vapor deposition chamber.

Figure 5C is an isometric cross-sectional view of an anode assembly formed in an exemplary physical vapor deposition chamber.

Figure 6A is a cross-sectional view of a conductive member assembly which may be useful to perform aspects of the invention disclosed herein.

Figure 6B is a cross-sectional view of a conductive member assembly which may be useful to perform aspects of the invention disclosed herein.

Figure 6C is a cross-sectional view of a conductive member assembly which may be useful to perform aspects of the invention disclosed herein.

Figure 7A is a plan view illustrating an orientation of a target, anode assemblies and magnetron assembly which may be useful to perform aspects of the invention disclosed herein.

Figure 7B is a plan view illustrating an orientation of a target, anode assemblies and magnetron assembly which may be useful to perform aspects of the invention disclosed herein.

Figure 8 is an isometric cross-sectional view of a lower chamber assembly in an exemplary physical vapor deposition chamber according to this invention.

Figure 9 is an isometric cross-sectional view of a lower chamber assembly in an exemplary physical vapor deposition chamber according to this invention.

Figure 10A is an isometric cross-sectional view of a lower chamber assembly in an exemplary physical vapor deposition chamber according to this invention.

Figure 10B is a close-up view isometric cross-sectional view a conductive member shown in Figure 10A that may be useful to perform aspects of the invention disclosed herein.

Figure 11A is a vertical cross-sectional view of a processing region formed in an exemplary physical vapor deposition chamber according to this invention.

Figure 11B is a vertical cross-sectional view of a processing region formed in an exemplary physical vapor deposition chamber according to this invention.

Figure 11C is a vertical cross-sectional view of a processing region formed in an exemplary physical vapor deposition chamber according to this invention.

Figure 11D is a vertical cross-sectional view of a processing region formed in an exemplary physical vapor deposition chamber according to this invention.

Figure 11E is an isometric cross-sectional view a conductive member that may be useful to perform aspects of the invention disclosed herein.

Figure 12A is a vertical cross-sectional view of an exemplary physical vapor deposition chamber according to this invention.

Figure 12B is a horizontal cross-sectional view of a motion assembly schematically illustrated in Figure 6, which may useful to perform aspects of the invention disclosed herein.

Figure 13 is an isometric cross-sectional view of an anode assembly formed in an exemplary physical vapor deposition chamber according to this invention.

### DETAILED DESCRIPTION

The present invention generally provides an apparatus and method for processing a surface of a substrate in a PVD chamber that has an increased anode surface area to improve the deposition uniformity. In general, aspects of the present invention can be used for flat panel display processing, semiconductor processing, solar cell processing, or any other substrate processing. The invention is illustratively described below in reference to a physical vapor deposition system, for processing large area substrates, such as a PVD system, available from AKT, a division of Applied Materials, Inc., Santa Clara, California. In one embodiment, the processing chamber is adapted to process substrates that have a surface area of at least about 2000 cm². In another embodiment, the processing chamber is adapted to process substrates that have a surface area of at least about 19,500 cm² (e.g., 1300 mm x 1500 mm). However, it should be understood that the apparatus and method may have utility in other system configurations, including those systems configured to process large area round substrates.

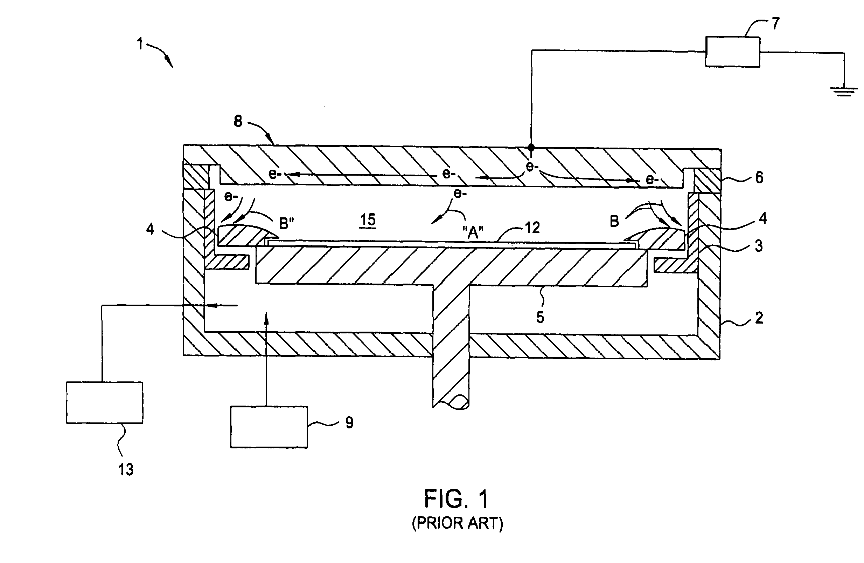

Figure 1 illustrates a cross-sectional view of the processing region of a conventional physical vapor deposition (PVD) chamber 1. The conventional PVD chamber 1 generally contains a target 8, a vacuum chamber 2, a grounded shield 3, a shadow ring 4, a target electrical insulator 6, a DC power supply 7, a process gas source 9, a vacuum pump system 13 and a substrate support 5. To perform a sputtering process, a process gas, such as argon, is delivered into the evacuated conventional PVD chamber 1 from the gas source 9 and a plasma is generated in the processing region 15 due to a negative bias created between the target 8 and the grounded shield 3 by use of the DC power supply 7. In general, the plasma is primarily generated and sustained by the emission of electrons from the surface of the target due to the target bias and secondary emission caused by the ion bombardment of the negative (cathodic) target surface. Prior to performing the PVD processing step(s) it is common for the vacuum chamber 2 to be pumped down to a base pressure (e.g., 10⁻⁶ to 10⁻⁹ Torr) by use of the vacuum pump system 13.

Figure 1 is intended to illustrate one of the believed causes of the plasma non-uniformity in a large area substrate processing chamber by highlighting the path difference between the an electron (see e⁻) ejected from the surface of the target 1 near the center of the target (see path "A") and electrons emitted from the surface of the target near the edge (see path "B"). While the longer path to ground experienced by an electron leaving the center of the target may increase the number of collisions the electron will undergo before it is lost to the anode surface or recombined with an ion contained in the plasma, the bulk of the electrons emitted from the target 8 will be emitted near the edge of the target due to the reduced electrical resistance of this path to ground. The reduced electrical resistance of the path near the edge of the target to ground is due to the lower resistance path through the conductive target 8 material(s) and the shorter path length ("B") of the electron's path to ground. The lower resistance path thus tends to increase the current density and plasma density near the edge of the target, thus increasing the amount of material sputtered at the edge versus the center of the target 1.

### Increased Anode Area Hardware

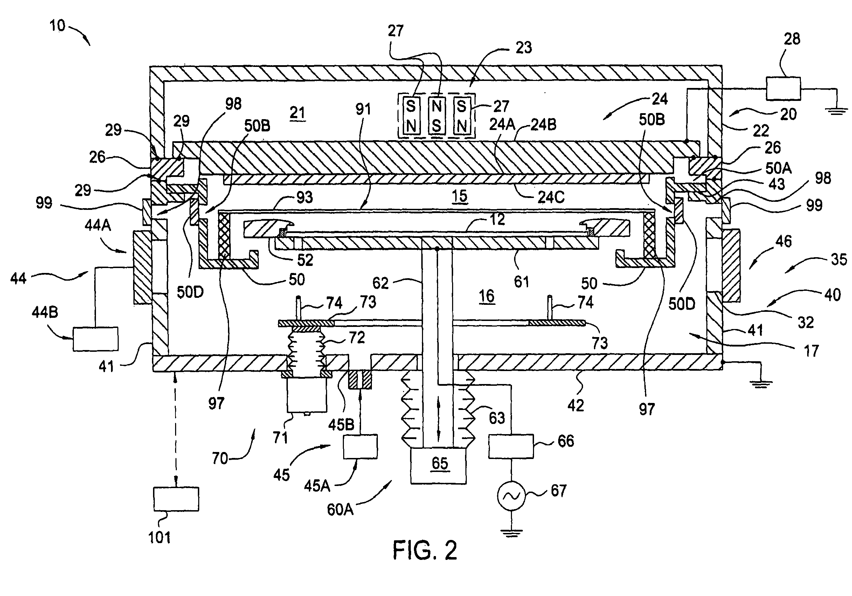

Figure 2 illustrates a vertical cross-sectional view of one embodiment of a processing chamber 10 that may be used to perform aspects of the invention described herein. In the configuration illustrated in Figure 2, the processing chamber 10 contains one or more anode assemblies 91 (plurality of anodic members) that are used to increase and more evenly distribute the anodic surfaces throughout the processing region 15. Figure 2 illustrates a substrate 12 that is positioned in a processing position in the processing region 15. In general, the processing chamber 10 contains a lid assembly 20 and a lower chamber assembly 35.

### A. Lid Assembly and Magnetron Hardware

The lid assembly 20 generally contains a target 24, a lid enclosure 22, a ceramic insulator 26, one or more o-ring seals 29 and one or more magnetron assemblies 23 that are positioned in a target backside region 21. In one aspect, the ceramic insulator 26 is not required to provide electrical isolation between the backing plate 24B of the target 24 and the chamber body assembly 40. In one aspect of the process chamber 10, a vacuum pump (not shown) is used to evacuate the target backside region 21 to reduce the stress induced in the target 24 due to the pressure differential created between the processing region 15 and the target backside region 21. The reduction in the pressure differential across the target 24 can be important for process chambers 10 that are adapted to process large area substrates greater than 2000 cm² to prevent the large deflections of the center of the target 24. Large deflections are often experienced even when the pressure differential is about equal to atmospheric pressure (e.g., 14 psi).

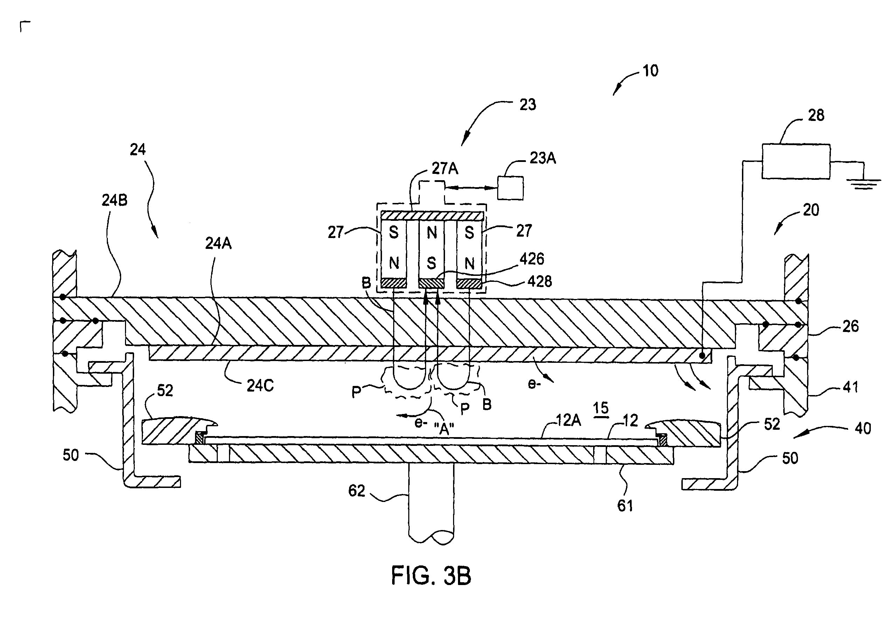

Referring to Figure 2, each magnetron assembly 23 will generally have at least one magnet 27 that has a pair of opposing magnetic poles (*i*.*e*., north (N) and south (S)) that create a magnetic field (B-field) that passes through the target 24 and the processing region 15 (see element "B" in Figure 3B). Figures 2 and 3B illustrate a cross-section of one embodiment of a processing chamber 10 that has one magnetron assembly 23 that contain three magnets 27, which are positioned at the back of the target 24. It should be noted that while the target 24, illustrated in Figure 2, has a backing plate 24B and target material 24A, other embodiments of the invention may use a solid, or monolithic, type target without varying from the basic scope of the invention.

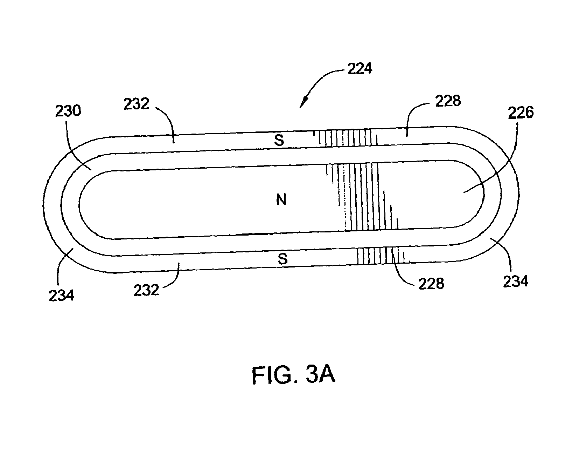

Figure 3A illustrates a plan view of a magnetron 224 that has two poles 228 and 226 which are typically positioned parallel to the front face of the target 24C (Figure 3B). In one aspect, as shown in Figure 3A, the magnetron assembly 23 may be formed by a central pole 226 of one magnetic polarity surrounded by an outer pole 228 of the opposite polarity to project a magnetic field "B" within the processing region 15 of chamber 10 (Figure 3B). The two poles 226, 228 are separated by a substantially constant gap 230 over which a high-density plasma is formed under the correct chamber conditions and gas flows in a closed loop or closed track region (e.g., elements "P" in Figure 3B). The outer pole 228 consists of two straight portions 232 connected by two semi-circular arc portions 234. The magnetic field formed between the two poles 226, 228 traps electrons and thereby increases the density of the plasma and as a result increases the sputtering rate. The relatively small widths of the poles 226, 228 and of the gap 230 produce a high magnetic flux density. The closed shape of the magnetic field distribution along a single closed track forms a plasma loop generally following the gap 230. A closed loop is generally desirable since this configuration generally prevents plasma from leaking out the ends of a plasma loop that is not a closed loop shape. During the PVD deposition process a large portion of the generated plasma in the processing region 15 is formed and is retained below the magnetron assemblies 23 in the plasma loop due to the magnetic fields (elements "B" in Figure 3B) containment of the electrons found in the processing region 15. The optimum shape of the generated plasma will vary from one substrate size to another, from the ratio of the anode (e.g., grounded surface) to cathode (e.g., target) surface area, target to substrate spacing, PVD process pressure, motion of the magnetron across the target face, desired deposition rate, and type of material that is being deposited. The effectiveness of the magnetron 23 on reducing the center to edge deposited thickness variation is affected by the magnetic permeability of the target material(s) and the translation of the magnetron assembly 23. Therefore, in some cases the magnetron magnetic field pattern may need to be adjusted based on the type of target 24 material(s) and their thickness(es).

In one aspect, the magnetron assembly 23 is smaller in size than the target 24 and is translated across the back of the target 24 to assure full utilization of the target surface 24C. Typically, to improve utilization of the target material and improve deposition uniformity it is common to translate (e.g., raster, scan, and/or rotate) each magnetron assembly in at least one of the directions that are parallel to the target surface (elements 24C in Figure 3B) by use of one or more magnetron actuators (elements 24A). The magnetron actuator(s) may be a linear motor, stepper motor, or DC servo motor adapted to position and move the magnetron assembly in a desired direction at a desired speed by use of commands from the controller 101 (discussed below). A translation mechanism used to move the magnetron, along with magnet orientations in the magnetron assembly, that may be adapted to benefit the invention described herein is further described in the commonly assigned United States Patent Application Serial No. 10/863,152 [AMAT 8841], filed June 7^{th}, 2004, which claims the benefit of United States Provisional Patent Application Serial No. 60/534,952, filed January 7th, 2004, and United States Patent Application Serial No. 10/863,152 [AMAT 8841.P1], filed August 24^{th}, 2005, which are hereby incorporated by reference in their entirety to the extent not inconsistent with the claimed invention.

Figure 3B illustrates a vertical sectional view of one embodiment of the processing chamber 10 illustrated in Figures 2 and 3A that contains a magnetron assembly 23. Figure 3B also illustrates a close up view of one embodiment of the processing region 15 and lid assembly 20. The embodiment generally contains a lid assembly 20 that has a target 24 and at least one magnetron assembly 23 positioned adjacent to the target 24.

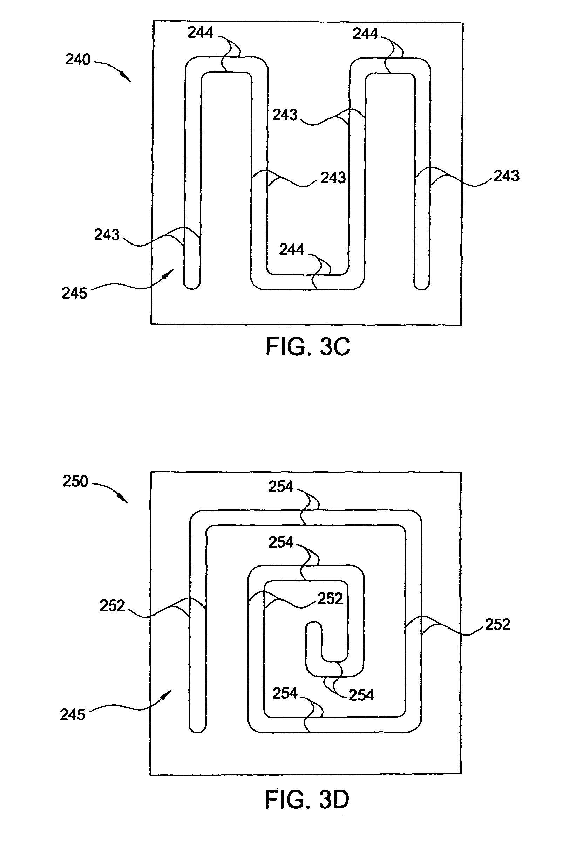

Referring to Figure 3B, in one embodiment, the magnetron assembly 23 is formed using a central pole 426 and outer pole 428 that have a convoluted shape rather than a linear shape as illustrated in Figure 3A. Figures 3C and 3D schematically illustrate the plan view of the shape of a plasma loop 245 created in the processing region 15 below a target surface 24C (see Figure 3B), which is formed using two different convoluted magnetron assembly shapes that will hereafter be described as a serpentine magnetron 240 (Figure 3C) or spiral magnetron 250 (Figure 3D). Referring to Figure 3C, to form the plasma loop 245 the serpentine magnetron 240 will generally include multiple long parallel straight portions 243 that are joined by end portions 244. The end portions 244 may have short straight portions with curved corners, as shown in Figure 3C, or alternatively arc shaped, which connect them to the straight portions 243. The effective area of the serpentine magnetron 240 defined by the outer edge of generally rectangular outline of the magnetic field distribution parallel to the target face is a substantial fraction of target area. Referring to Figure 3D, in a related embodiment, a plasma loop 245 may be formed using a spiral magnetron 250 that includes a series of straight portions 252 and 254 that extend along perpendicular axes and are smoothly joined together to form a plasma loop that has a rectangular spiral shape. While Figure 3D illustrates a rectangular type spiral configuration this is not intended to limit the scope of the invention, since any shaped arrangement of poles that winds around itself in a spiral fashion may be used.

The plasma loop formed by the magnetron shapes illustrated in Figures 3C and 3D are intended to be a schematic representation of some magnetron configurations that may be useful to perform various aspects of the invention described herein. One will note that the number of folds and the distance between the plasma loops in either magnetron 240, 250 may be significantly adjusted as required to achieve a desired process uniformity or deposition profile. The term sputter deposition profile is intended to describe the deposited film thickness as measured across the substrate processing surface (element 12A in Figure 3B). Although it is not necessary, each of the magnetrons may be considered a folded or twisted version of an extended racetrack magnetron of Figure 3A with a plasma loop formed between the inner pole and the surrounding outer pole.

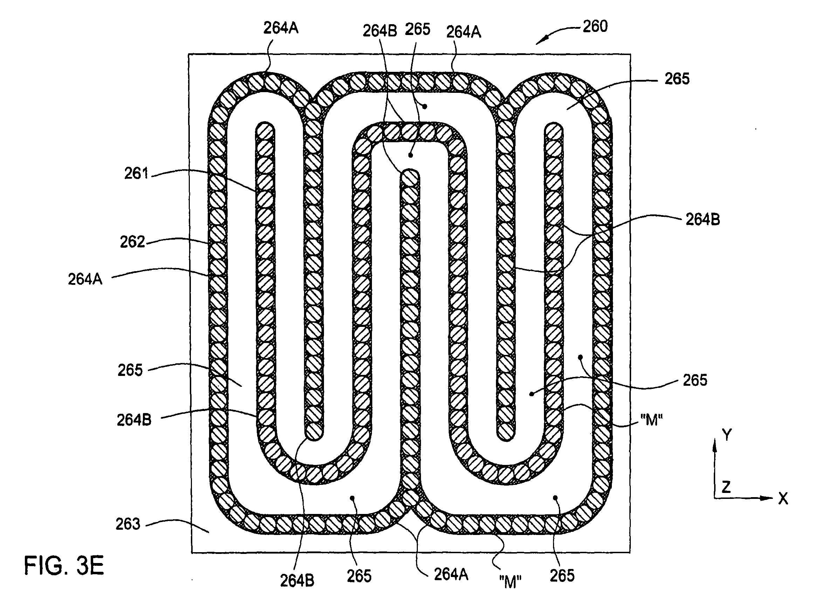

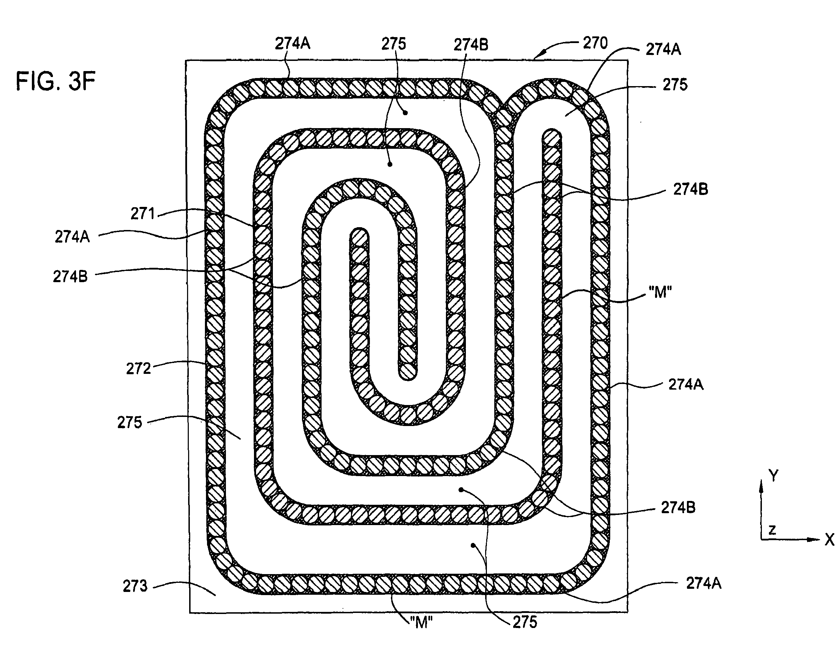

Figures 3E and 3F illustrate schematic plan views of two magnetron assemblies, serpentine magnetron assembly 260 and spiral magnetron assembly 270, that are closed convoluted magnetron shapes that are useful to perform aspects of the invention described herein. Figure 3E illustrates one embodiment of a serpentine magnetron assembly 260 that has an array of magnets that are aligned and arranged in grooves 264A-B formed in the magnetron plate 263 to form a first pole 261 and a second pole 262. The two opposing poles, such as first pole 261 and the second pole 262, form a magnetic field in the gaps 265 formed between the first pole 261 and second pole 262. In one aspect, the serpentine magnetron assembly 260, as illustrated in Figure 3E, is formed using an array of magnets, which are schematically illustrated by the array of circles "M", that are oriented so that the first pole 261 forms the north pole (elements "N") of the magnetron assembly and the second pole 262 forms the south pole (elements "S") of the magnetron assembly. Generally, the magnets used to form the first pole 261 and second pole 262 as described herein may be permanent magnets (e.g., neodymium, samarium-cobalt, ceramic, or Alnico) or electromagnets. The width of the outer grooves 264A, which are at the edge of the magnetron assembly is generally about half the widths of the inner grooves 264B since the outer grooves 264A accommodate only a single row of magnets while the inner groove 264B accommodate two rows of magnets (not shown) in a staggered arrangements to balance the generated magnetic field strength between the poles. In one aspect, a single magnetic yoke plate (element 27A Figure 3B) may cover the back of the magnetron plate 263 to magnetically couple the poles of all the magnets. In one aspect, the magnets positioned in grooves 264A and 264B are capped with their respective pole pieces that are typically formed of magnetically soft stainless steel and have a shape and width that is approximate equal to the formed grooves 264A or 264B.

Figure 3F illustrates one embodiment of a spiral magnetron assembly 270 that has an array of magnets 27 that are aligned and arranged in grooves 274A-B formed in the magnetron plate 273 to form a first pole 271 and a second pole 272. The two opposing poles, such as first pole 271 and the second pole 272, form a magnetic field in the gaps 275 formed between the first pole 271 and second pole 272. In one aspect, the spiral magnetron assembly 270, as illustrated in Figure 3F, is formed using an array of magnets, which are schematically illustrated by the array of circles "M", that are oriented so that the first pole 271 forms the north pole (elements "N") of the magnetron assembly and the second pole 272 forms the south pole (elements "S") of the magnetron assembly. The width of the outer grooves 274A, which are at the edge of the magnetron assembly is generally about half the widths of the inner grooves 274B since the outer grooves 274A accommodate only a single row of magnets while the inner groove 274B accommodate two rows of magnets (not shown) in a staggered arrangements to balance the generated magnetic field strength between the poles. In one aspect, a single magnetic yoke plate may cover the back of the magnetron plate 273 to magnetically couple the poles of all the magnets. In one aspect, the magnets 27 positioned in grooves 274A and 274B are capped with their respective pole pieces that are typically formed of magnetically soft stainless steel and have a shape and width that is approximate equal to the formed grooves 274A or 274B.

Referring to Figures 3E and 3F, it is important to note that the orientation of the poles in a convoluted magnetron assembly (e.g., serpentine magnetron assembly 260) will generate magnetic fields that may not be symmetric in every direction. It should be noted that at any point across the magnetron assembly the magnetic field, or magnetic flux, can be broken up into three components, Bₓ, B_{y} and B_{z}, which correspond to the magnetic field in the X, Y and Z-directions. The components Bₓ and B_{y} are tangential to the page and B_{z} is normal to the page of Figure 3E or 3F. The magnetic flux generated between the two poles will primarily follow a path that is the shortest distance between the poles (e.g., elements 261, 262 or elements 271, 272) and thus will generally follow a tangential path (*e*.*g*., Bₓ and B_{y}) that is perpendicular to the gaps (*e*.*g*., elements 265 or 275) formed between the poles. It is believed that the orientation of the poles in the serpentine magnetron assembly 260 pattern will have a preferential magnetic field generation direction (*e.g.,* Bₓ), since the poles 261, 262 are primarily aligned parallel to each other in the Y-direction. However, the orientation of the poles in the spiral magnetron assembly 270 pattern will tend to be more uniform in the X-direction and Y-direction since the straight lengths of the poles 271, 272 are generally equal in length in the X and Y-directions. The term "preferential magnetic field generation direction" is generally used herein to describe a direction in which the highest generated magnetic flux density is formed at any given point along the magnetron assembly. The preferential magnetic field generation direction may vary in different regions of magnetron assembly 23 and thus an average preferential magnetic field generation direction can be calculated by vector sum of all of the magnetic fields generated by the magnetron assembly 23.

### B. Lower Chamber Assembly Hardware

Referring to Figure 2, the lower chamber assembly 35 generally contains a substrate support assembly 60, chamber body assembly 40, a shield 50, a process gas delivery system 45 and a shadow frame 52. The shadow frame 52 is generally used to shadow the edge of the substrate to prevent or minimize the amount of deposition on the edge of a substrate 12 and substrate support 61 during processing (see Figure 2). In one embodiment, the chamber body assembly 40 generally contains one or more chamber walls 41 and a chamber base 42. The one or more chamber walls 41, the chamber base 42 and target 24 generally form a vacuum processing area 17 that has a lower vacuum region 16 and a processing region 15. In one aspect, a shield mounting surface 50A of the shield 50 is mounted on or connected to a grounded chamber shield support 43 formed in the chamber walls 41 to ground the shield 50. The process gas delivery system 45 generally contains one or more gas sources 45A that are in fluid communication with one or more inlet ports 45B that are in direct communication with the lower vacuum region 16 (shown in Figure 2) and/or the processing region 15, to deliver a process gas that can be used during the plasma process. Typically, the process gas used in PVD type applications is, for example, an inert gas such as argon, but other gases such as nitrogen may be used. In one embodiment, the substrate support 61 may contain RF biasable elements (not shown) embedded within the substrate support 61 that can be used to capacitively RF couple the substrate support 61 to the plasma generated in the processing region 15 by use of an RF power source 67 and RF matching device 66. The ability to RF bias the substrate support 61 may be useful to help improve the plasma density, improve the deposition profile on the substrate, and increase the energy of the deposited material at the surface of the substrate.

The substrate support assembly 60 generally contains a substrate support 61, a shaft 62 that is adapted to support the substrate support 61, and a bellows 63 that is sealably connected to the shaft 62 and the chamber base 42 to form a moveable vacuum seal that allows the substrate support 61 to be positioned in the lower chamber assembly 35 by the lift mechanism 65. The lift mechanism 65 may contain a conventional linear slide (not shown), pneumatic air cylinder (not shown) and/or DC servo motor that is attached to a lead screw (not shown), which are adapted to position the substrate support 61, and substrate 12, in a desired position in the processing region 15.

Referring to Figure 2, the lower chamber assembly 35 will also generally contain a substrate lift assembly 70, slit valve 46 and vacuum pumping system 44. The lift assembly 70 generally contains three or more lift pins 74, a lift plate 73, a lift actuator 71, and a bellows 72 that is sealably connected to the lift actuator 71 and the chamber base 42 so that the lift pins 74 can remove and replace a substrate positioned on a robot blade (not shown) that has been extended into the lower chamber assembly 35 from a central transfer chamber (not shown). The extended robot blade enters the lower chamber assembly 35 through the access port 32 in the chamber wall 41 and is positioned above the substrate support 61 that is positioned in a transfer position (not shown). The vacuum pumping system 44 (elements 44A and 44B) may generally contains a cryo-pump, turbo pump, cryo-turbo pump, rough pump, and/or roots blower to evacuate the lower vacuum region 16 and processing region 15 to a desired base and/or processing pressure. A slit valve actuator (not shown) which is adapted to position the slit valve 46 against or away from the one or more chamber walls 41 may be a conventional pneumatic actuator which are well known in the art.

To control the various processing chamber 10 components and process variables during a deposition process, a controller 101 is used. The processing chamber's processing variables may be controlled by use of the controller 101, which is typically a microprocessor-based controller. The controller 101 is configured to receive inputs from a user and/or various sensors in the plasma processing chamber and appropriately control the plasma processing chamber components in accordance with the various inputs and software instructions retained in the controller's memory. The controller 101 generally contains memory and a CPU which are utilized by the controller to retain various programs, process the programs, and execute the programs when necessary. The memory is connected to the CPU, and may be one or more of a readily available memory, such as random access memory (RAM), read only memory (ROM), floppy disk, hard disk, or any other form of digital storage, local or remote. Software instructions and data can be coded and stored within the memory for instructing the CPU. The support circuits are also connected to the CPU for supporting the processor in a conventional manner. The support circuits may include cache, power supplies, clock circuits, input/output circuitry, subsystems, and the like all well known in the art. A program (or computer instructions) readable by the controller 101 determines which tasks are performable in the plasma processing chamber. Preferably, the program is software readable by the controller 101 and includes instructions to monitor and control the plasma process based on defined rules and input data.

### Anode Assembly

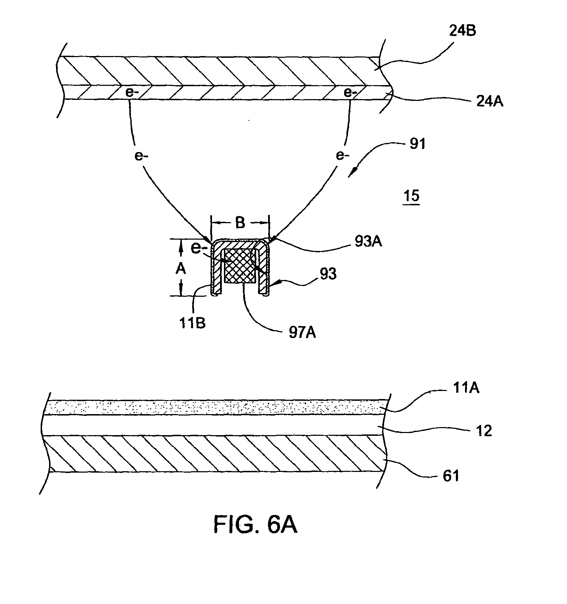

In one embodiment of the process chamber 10, illustrated in Figure 2, 4 and 5A, the lower chamber assembly 35 may contain one or more anode assemblies 91. In one embodiment, each anode assembly 91 contains a conductive member 93 and a conductive member support 97 that extends through the processing region 15. The anode assemblies 91 are grounded so that plasma generated in the processing region 15 is more uniform due to the more even distribution of the anode surfaces relative to all areas of the target surface 24C. In this configuration the conductive member 93 is in electrical contact with the grounded shield 50, so that current flowing through the conductive member 93 passes through the shield 50 to ground. In one embodiment, the conductive member 93 is positioned over the stationary conductive member support 97 and is used to hide or isolate the conductive member support 97 from the plasma generated in the processing region 15 (Figure 6A). The ability to hide or isolate the conductive member 97 from the plasma will reduce the amount of deposition that will land on the stationary conductive member support 97 and thus minimize particle generation as the conductive member 93 is removed from processing region 15 of the process chamber 10. In one embodiment, the anode assembly 91 is longer than the target surface 24C in the dimension in the direction in which the anode assembly 91 extends and thus the conductive member support(s) 97 are not positioned below the target surface 24C so as to limit the interaction between the plasma generated in the processing region 15 and the conductive member support(s) 97.

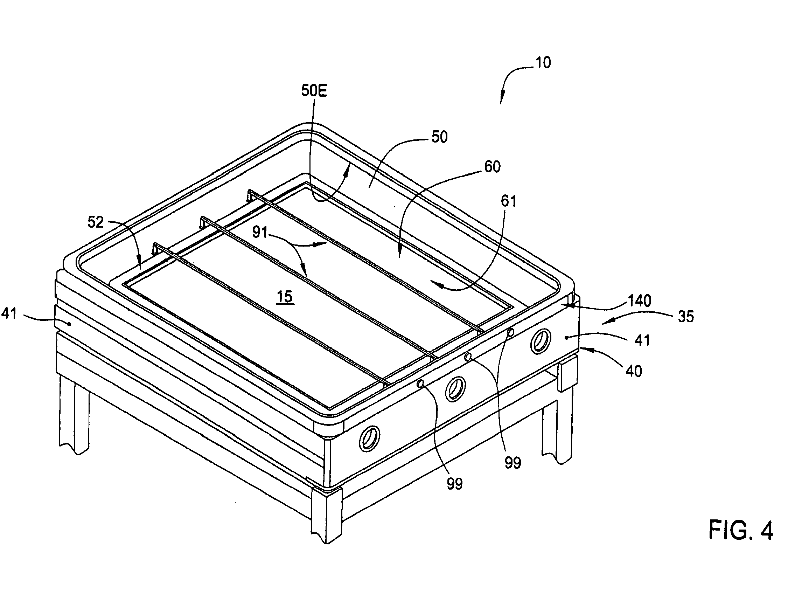

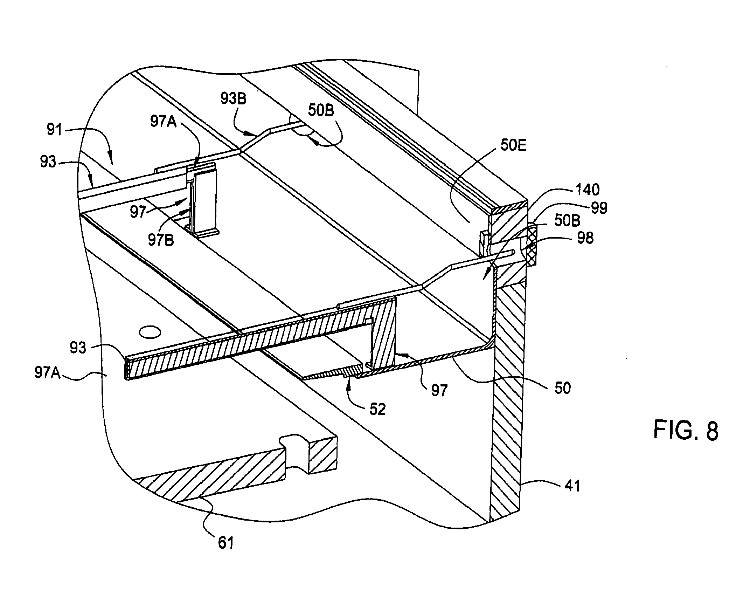

Figure 4 is an isometric view of one embodiment of the process chamber 10 that is intended to illustrate the configuration of one or more anode assemblies 91 that are positioned in the processing region 15. In Figure 4 the lid assembly 20 has been removed, and is not shown, to more clearly illustrate some of the components in the lower processing chamber assembly 35. In the embodiment shown in Figure 4, the lower chamber assembly 35 generally contains a substrate support assembly 60, chamber body assembly 40, a process gas delivery system (not shown; see Figure 2) and a shadow frame 52. In one aspect, as shown in Figure 4 the chamber body assembly 40 generally contains a process kit holder 140, one or more chamber walls 41 and a chamber base 42 (Figure 2). The process kit holder 140 is positioned on the chamber walls 41 and is adapted to support the shield 50, an upper shield 50E (Figure 8) and one or more anode assemblies 91 (e.g., three shown in Figure 4). In one aspect, the process kit holder 140 electrically connects the shield 50 and the upper shield 50E to the chamber walls 41 which are grounded. The shield 50 and upper shield 50E are generally sized and adapted to prevent the plasma and sputtered target material from escaping from the process region 15 and depositing on the components in the lower chamber assembly 35. In the configuration illustrated in Figure 4 the lower chamber assembly 35 contains three anode assemblies 91 that are positioned above the substrate support 61. In one aspect, as shown in Figures 2 and 4, the conductive member support 97 is mounted on and electrically connected to the grounded shield 50.

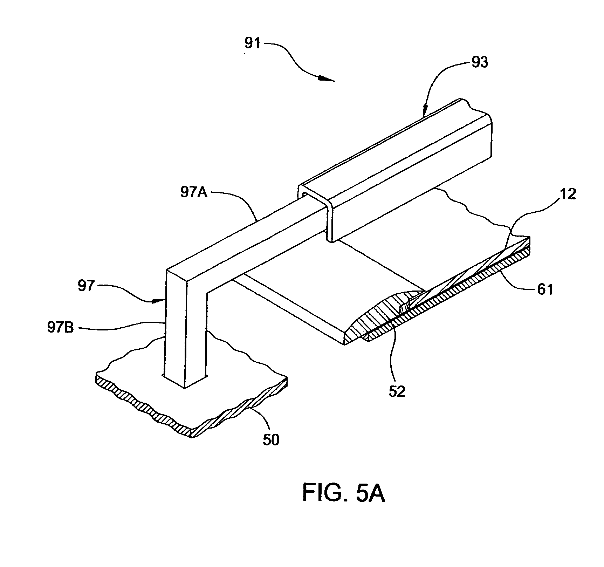

Figure 5A illustrates an isometric view of one embodiment of the anode assembly 91 that is connected to the shield 50 and is positioned above a substrate support 61 that has a substrate 12 and shadow frame 52 positioned thereon. In this view the conductive member 93 has been moved to the side to illustrate the relative position of the conductive member support 97 to the conductive member 93 and substrate support 61 during processing. In this configuration the conductive member support 97 generally contains a vertical support 97B and a horizontal support 97A that are adapted to support the conductive member 93 and are electrically connected and supported by the shield 50.

Figures 6A-6B illustrate vertical cross-sectional views of the processing region 15 and conductive member 93 that is intended to conceptually illustrate the current flow path from the target to the grounded conductive member 93. Figure 6A illustrates a vertical cross-sectional view of the processing region 15, a target 24 (elements 24A and 24B), a conductive member 93 and a deposited film 11 formed a substrate 12 positioned on a substrate support 61.

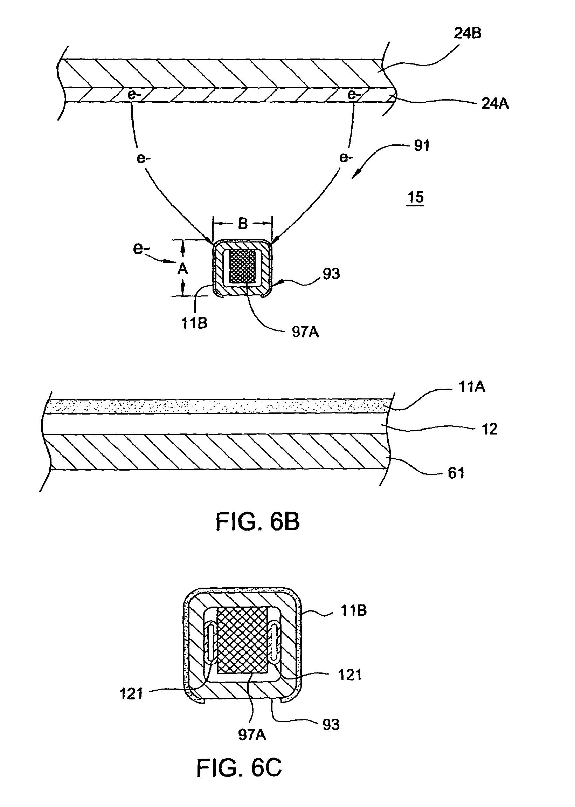

Referring to Figures 5A and 6A, in one aspect, the conductive member 93 may be made from sheet metal, or be formed from a metal block that is adapted to rest on the conductive member support 97. In another aspect, referring to Figure 6B, the conductive member 93 may be made from a stock round, square or rectangular tubing that is adapted to rest on and cover the conductive member support 97. The conductive member 93 can be made from a conductive metal such as, for example, titanium, aluminum, platinum, copper, magnesium, chrome, manganese, stainless steel, hastelloy C, nickel, tungsten, tantalum, iridium, ruthenium and alloys and/or combination thereof. Generally, the conductive member 93 and conductive member support 97 needs to be sized and made from a material that is conductive enough to receive a significant portion of the generated current created by the target bias, while also being made from a material that has a high enough melting point and is strong enough to not appreciably deform under the weight of the deposited material at the high temperatures that will be seen during processing. The high temperatures will likely be created by radiative type heat transfer and IR drop heating from the flow of current through the conductive member 93 and the conductive member support 97.

Referring to Figures 6A-B, in one aspect, since the PVD deposition process is primarily a line of sight type process the position of the conductive member 93 relative to the surface of the substrate 12 and target 24 may need to be optimized to reduce its shadowing effect on the deposited film. Shadowing of the substrate surface will affect the uniformity of the deposited layer formed on the surface of the substrate. The optimum distance of the conductive member 93 to the surface of the substrate 12 may vary depending on the gas pressure in the processing region 15, the sputtering process power and the distance between the substrate 12 and the target surface 24C. In general the conductive member 93 may be placed about half way between the target and the substrate. For example, where the substrate to target spacing is 200 mm, the conductive member 93 may be positioned at a distance of about 100 mm from the target. In one aspect, the one or more conductive members 93 positioned in the processing region 15 are placed a fixed distance between about 70 mm and about 130 mm from the target surface 24C.

It should be noted that the cross-sectional area and the material used to form the components in the anode assembly 91 (e.g., the conductive member 93 and the conductive member support 97) may be important since it will affect the its ability to withstand the high temperatures that it will be seen during processing (e.g., resistive heating and interaction with the plasma). The number of anode assemblies 91 and the surface area of the conductive member 93 exposed in the processing region 15 may also be important since it will have an effect amount of current carried by each conductive member 93 and thus the maximum temperature achieved by each conductive member 93 and conductive member support 97 during processing. The total surface area of the conductive member 93 can be defined by the length of the conductive member 93 in the processing region times the length of the exposed perimeter of the conductive member 93 times the number of conductive members positioned in the processing region. In one aspect, the number of anode assemblies 91 positioned in the processing region 15 may be between about 1 and about 20 depending on the desired process uniformity, cost and complexity allowed for a desired application. Preferably, the number of anode assemblies 91 that pass through the processing region 15 is between about 2 and about 10. The exposed perimeter of the embodiment of the conductive member 93 illustrated in Figure 6A can generally be defined as twice the vertical length "A" plus the horizontal length "B" of surface 93A of the conductive member 93 (e.g., perimeter = 2A + B; see Figures 6A and 6B). In one example, for a substrate that is 1800mm x 1500 mm in size the exposed surface area of all of the conductive members 93 was about 5.0 m², which is spread across 7 conductive members 93 that were 1.9 meters long. In one aspect, the cross-sectional area of the conductive member 93 is sized to carry the current delivered to the conductive members 93 from the plasma generated by the target bias. In one example, the total current that could be carried by all of the conductive members is about 1000 amps.

While Figures 6A and 6B illustrate a conductive member 93 that has a somewhat square cross-sectional shape, this configuration is not intended to be limiting as to the scope of the invention. In one aspect, it may be desirable to make the horizontal length "B" (Figures 6A and 6B) smaller than the vertical length "A" to reduce the shadowing of sputtered material passing from the target to the substrate surface during the deposition process.

Figure 6C illustrates one embodiment of an anode assembly 91 in which an electrical connector 121 is positioned between the conductive member 93 and the conductive member support 97 to enhance the electrical connection between the two parts. In one aspect, the electrical connector 121 is a conventional EMI or RF gasket that is bonded or welded to the conductive member 93 or the conductive member support 97.

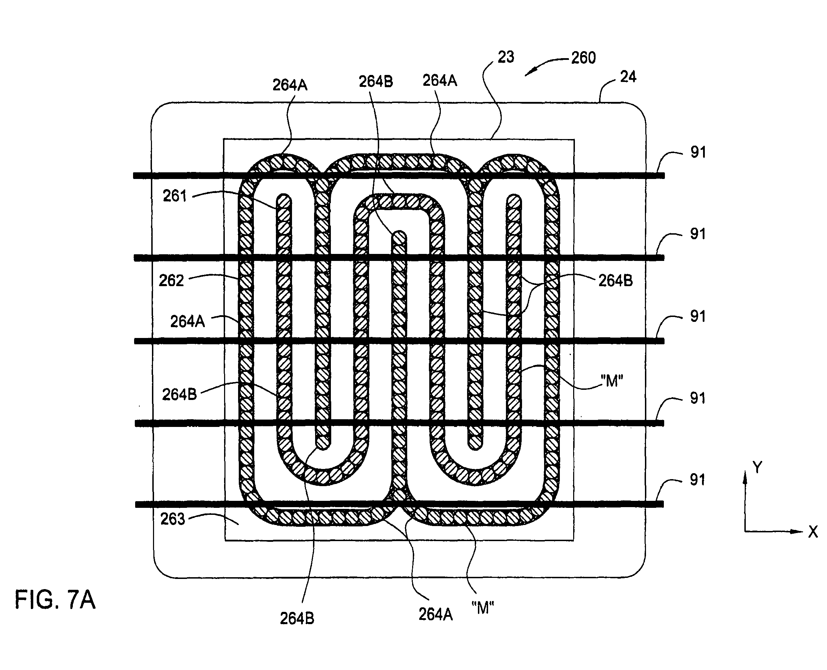

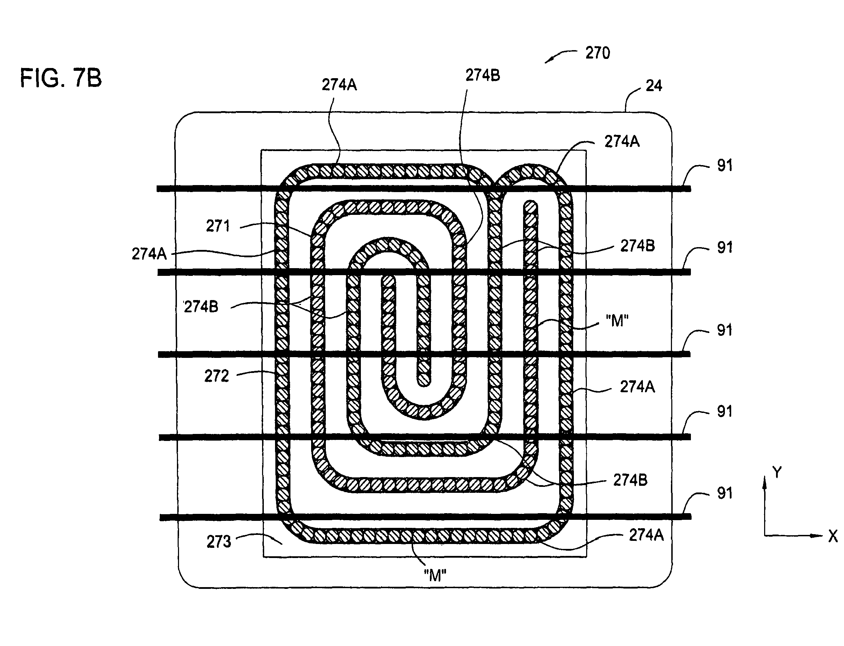

While Figures 4, 5A-B, 7A-B, 8, and 9 illustrate embodiments of the anode assembly 91 that are generally straight and are generally rod or bar shaped this configuration is not intended to limit the scope of the invention described herein. In general, the term bar, or rod, shaped as used herein is intended to described a component that is longer (e.g., X-direction in Figures 7A-B) than its cross-section is wide or high. In one aspect, the bar or rod shaped anode assemblies 91 are not straight and thus have one or more regions along their length that have a curved or coiled. In one embodiment, the anode assemblies 91 are positioned throughout the processing region to improve the sputter deposited film uniformity on the substrate surface by increasing the anode surface area and not appreciably obstructing or altering the amount and/or direction of the flux of sputtered material passing from the target to the substrate surface. Referring to Figures 6A and 6B, in one embodiment, the cross-section of the anode assembly 91 components (e.g., conductive member 93, conductive member support 97) are oval, round, diamond, or other cross-sectional shape that will not appreciably obstruct or alter the amount and/or direction of the flux of sputtered material passing from the target to the substrate surface.

To perform a PVD deposition process, the controller 101 commands the vacuum pumping system 44 to evacuate the processing chamber 10 to a predetermined pressure/vacuum so that the plasma processing chamber 10 can receive a substrate 12 from a system robot (not shown) mounted to a central transfer chamber (not shown) which is also under vacuum. To transfer a substrate 12 to the processing chamber 10 the slit valve (element 46), which seals off the processing chamber 10 from the central transfer chamber, opens to allow the system robot to extend through the access port 32 in the chamber wall 41. The lift pins 74 then remove the substrate 12 from the extended system robot, by lifting the substrate from the extended robot blade (not shown). The system robot then retracts from the processing chamber 10 and the slit valve 46 closes to isolate the processing chamber 10 from the central transfer chamber. The substrate support 61 then lifts the substrate 12 from the lift pins 74 and moves the substrate 12 to a desired processing position below the target 24. Then after a achieving a desired base pressure, a desired flow of a processing gas is injected into the processing region 15 and a bias voltage is applied to the target 24 by use of a power supply 28 to generate a plasma in the processing region 15. The application of a DC bias voltage by the power supply 28 causes the gas ionized in the processing region 15 to bombard the target surface and thus "sputter" metal atoms that land on the surface of the substrate positioned on the surface of the substrate support 61. In the configuration shown in Figure 2, a percentage of the generated current from the application of the bias voltage will pass through the grounded conductive member 93 and thus allow the generated plasma to be more uniformly distributed throughout the processing region. It should be noted that the term "grounded" is generally intended to describe a direct or in-direct electrical connection between the anode assembly 91 to the anode surfaces in the process chamber.

During processing and idle times, the temperature of the conductive member 93 will vary greatly thus possibly causing the film 11B deposited on the conductive member 93 to vary the shape of the conductive member 93 or cause the deposited material to flake and generate particles which can cause device yield problems on the processed substrate(s). In one aspect, to resolve this issue the surface 93A of the conductive member 93 may be roughened by grit blasting, chemical etching or other conventional techniques to increase the mechanical adhesion of the deposited film to the conductive member 93. In one aspect, the surface 93A is roughened to an average surface roughness (Rₐ) between about 1 and about 9 micrometers. In one embodiment, an aluminum arc spray, flame spray or plasma spray coating may be deposited on the surface 93A of the conductive member 93 to improve the adhesion of the deposited film. In one aspect, the surface 93A is roughened by use of the arc spray, flame spray or plasma spray coating to an average surface roughness (Rₐ) between about 1 and about 50 micrometers.

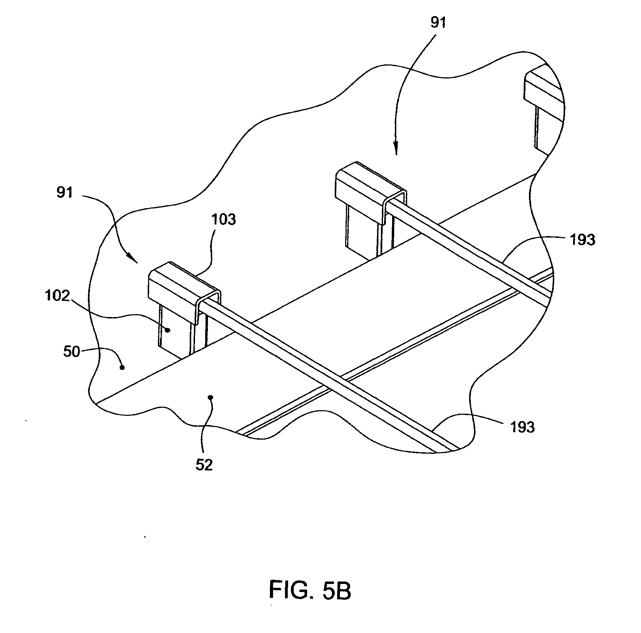

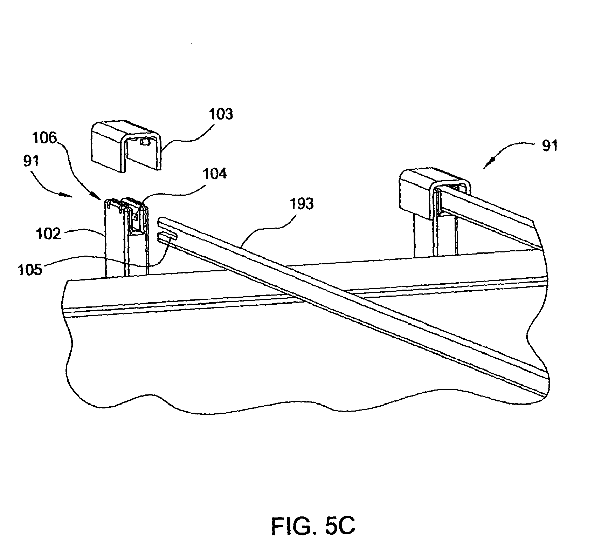

Figure 5B illustrates an isometric view of another embodiment of the anode assembly 91 (e.g., two shown in Figure 5B) that does not utilize the conductive member 93 as a shield for the conductive member support 97. In this embodiment, an unshielded conductive member 193 is used to transfer current from the plasma to the support 102 and finally to the grounded shield 50 (e.g., element 50 in Figure 2). In this configuration the unshielded conductive member 193 is directly deposited on during the PVD deposition process. Figure 5C illustrates an exploded isometric view of one anode assembly 91 where the unshielded conductive member 193 has a conductive member electrical connection point 105 that is adapted to electrically contact a support electrical connection point 104 of the support 102. In one aspect, the conductive member electrical connection point 105 and the support electrical connection point 104 act as a pivot point 106 that allows the unshielded conductive member 193 to be positioned in and/or removed from the processing region 15 (discussed below). Referring to Figures 5B and 5C, to hide the pivot point 106 a support cover 103 is positioned over this region to prevent the sputtered material deposition from inhibiting the removal of these components from the process region 15.

Referring to Figures 5B-C and 6B, in one aspect of the anode assembly 91, where a conductive member 93 surrounds the conductive member support 97 (see Figure 6B), the conductive member support 97 may have a pivot point 106 at one end and an end that is detachable from the other vertical support (not shown) to allow the conductive member 93 to be positioned over the conductive member support 97.

In one embodiment, not shown, the anode assemblies are cantilevered over the substrate surface and thus do not extend all the way across the substrate. In one aspect, the cantilevered end of the anode assemblies may only extend to a point that is above the center of the substrate positioned on the substrate support. In one aspect, the cantilevered anode assemblies are evenly distributed throughout the processing region 15.

While the embodiments of the process chamber 10 illustrated herein all show the anode assembly 91 in contact with the shield 50, this configuration is not intended to be limiting to the scope of the invention described herein. Therefore, in some embodiments the vertical support (e.g., element 97B Figure 5A and 8, element 102 in Figure 5B) may be mounted on a bracket or supporting surface positioned in the chamber body assembly 40.

**Anode Assembly Alignment**

In one aspect of the invention, to assure the uniform deposition across the processing surface of a substrate, the alignment, orientation and/or position of a feature (e.g., surface), or axis of symmetry, of the one or more of the anode assemblies 91 relative to the target 24, or substrate positioned on the substrate support 61, can be optimized. Figure 8A is a plan view that schematically illustrates an exemplary orientation of the target 24, a magnetron assembly 23 that has a serpentine magnetron assembly 240 within it, and a plurality of anode assemblies 91. In one embodiment, as shown in Figure 8A, the plurality of anode assemblies 91 (e.g., five shown) are equally spaced apart from each other in the Y-direction and are aligned in a direction perpendicular to the direction in which the poles 261 and 262 of the serpentine magnetron assembly 240 are primarily aligned (e.g., parallel to Y-direction). The magnetron assembly 23 in some cases may be moved in the X-Y plane across the surface of the target 24 during processing by use of an actuator 24A (not shown; see Figure 3B). In one aspect, the primary alignment of the poles 261 and 262 are designed to remain oriented perpendicular to the anode assembly 91 alignment direction during the movement of the magnetron assembly 23 by the actuator 23A. While Figure 7A illustrates a case where the generally bar shaped anode assemblies 91 are aligned in the long direction of a rectangular shaped target 24 and the poles of the serpentine magnetron assembly 240 are aligned perpendicular to the long direction of the substrate, this configuration is not intended to be limiting to the scope of the invention described herein. In one embodiment, it may be desirable to align the anode assemblies 91 in a direction that is parallel to the direction in which the poles 261 and 262 are primarily aligned. In one aspect, the anode assemblies are aligned relative to the average preferential magnetic field generation direction of a magnetron assembly or of all the magnetron assemblies.

Figure 8B is a plan view that schematically illustrates an exemplary orientation of the target 24, the magnetron assembly 23 and a plurality of anode assemblies 91. In one embodiment, as shown in Figure 8B, the plurality of anode assemblies 91 (e.g., five shown) are equally spaced apart from each other in the Y-direction and are positioned parallel and perpendicular to various sections of the spiral magnetron 250 type of magnetron assembly 23. In one aspect, the magnetron assembly 23 is moved in the X-Y plane across the surface of the target 24 during processing by use of an actuator 24A (Figure 3B). In one aspect, the primary alignment of the poles 271 and 272 are designed to remain in the same orientation relative to the anode assemblies 91 during the movement of the magnetron assembly 23 during processing.

Referring to Figures 7A-7B, in one aspect, it may be desirable to have more anode assemblies 91 positioned below the center of the target 24 and fewer below the edges of the target 24, and thus form a non-uniform distribution of anode assemblies 91 throughout the processing region 15. As noted above in conjunction with Figures 6A-6B, it may be desirable to position the anode assemblies at a desired distance from the surface of the target and the surface of the substrate to reduce the shadowing of the deposited material on the surface of the substrate.

### Conductive Member Removal

Referring to Figures 8-10, in one embodiment of the invention, the conductive member 93, or unshielded conductive member 193 (not shown; Figures 5B-5C), is adapted to be removed from the process chamber 10 through an access hole 50B formed in the shield 50 that is aligned with an access port 98 formed in the process kit holder 140. In one aspect, the access port 98 may be formed in the chamber wall 41, as illustrated in Figure 2. Figures 8-10 are isometric cross-sectional views that illustrate the conductive member 93 in various states of insertion or removal from the processing region 15 through the access hole 50B and the access port 98. In Figures 8-10, the lid assembly 20 has been removed to more clearly illustrate some of the components in the lower processing chamber assembly 35.

In one embodiment, the process chamber 10 generally contains a shield 50 and an upper shield 50E attached to the process kit holder 140 and positioned in the processing region 15 of the process chamber 10. The shield 50 and an upper shield 50E are adapted to collect stray deposited material generated during the plasma processing of a substrate. Generally, the shield 50 and upper shield 50E are designed to overlap so that they shadow the sputtered material so that it will not make its way to the access hole 50B and into the lower vacuum chamber 16. In one aspect, which is illustrated in Figure 2, the access hole 50B may be covered by an optional access hole cover 50D to prevent deposition of the sputtered target atoms in the lower vacuum region 16 during processing. The access hole cover 50D may be pivotally attached to the shield 50 so that it can be moved in and out of a position that covers the access hole 50B.

Figure 8 illustrates an isometric cross-sectional view of the lower chamber assembly 35 showing one end of the two anode assemblies 91. In the configuration shown in Figure 8 the conductive member supports 97 generally contain a vertical support 97B and a horizontal support 97A that are adapted to support the conductive member 93 that is positioned on the horizontal support 97A. In one embodiment, the conductive member 93 has a handle 93B that is attached or welded to the surface of the conductive member 93 to facilitate the insertion and/or removal of the conductive member 93 through the access hole 50B formed in the shield 50 and the access port 98 formed in the process kit holder 140.

Referring to Figure 8, when the conductive member 93 has reached its useable lifetime the conductive member 93 can be removed from the processing region 15 by venting the process chamber 10 and removing a blank-off plate 99 that is sealably attached to the process kit holder 140 so that a user can access the conductive member 93 through the access hole 50B and access port 98. The process of removing the conductive member 93 may include shutting "off' the vacuum pumps (not shown) and then delivering a flow of an inert gas, such as argon, into the vacuum processing area 17 from a gas source 45A (shown in Figure 2) to create a pressure greater than atmospheric pressure in the vacuum processing area 17. Creating a positive pressure in the processing area 17 during the removal of the conductive member 93 may be advantageous since it can prevent the contamination of the chamber components positioned in the processing region 15 due to the exposure of the process kit components to atmospheric contamination (e.g., atmospheric gases, vapors or particles). In one aspect, the access hole 50B and access port 98 are purposely kept as small as possible to minimize the area through which atmospheric contamination can enter the processing region 15. The down time of the processing chamber 10 can thus be minimized since there is no need to remove and reposition the chamber lid assembly 20 and/or other major chamber components, there is no need to bake out of the chamber to remove adsorbed gases and water from processing chamber components, and there is no need to replace contaminated components due to their exposure to atmospheric contamination.

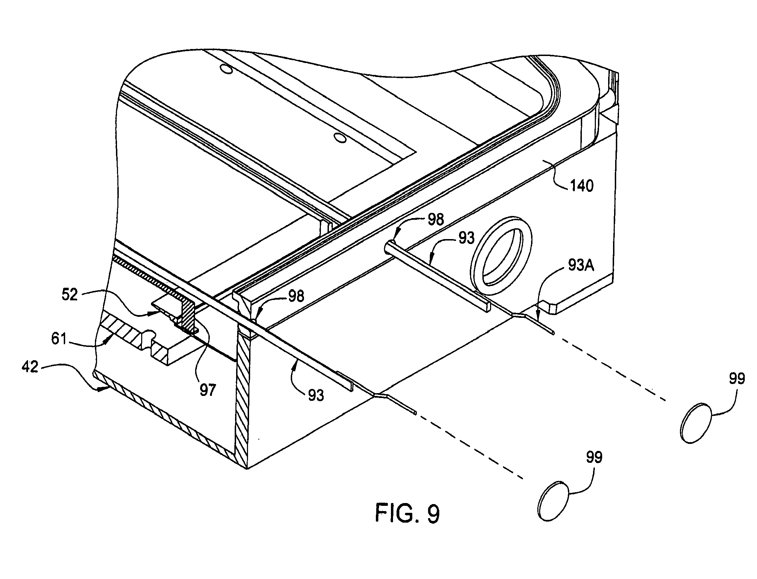

Figure 9 is an isometric cross-sectional exploded view as viewed from outside the process chamber 10 that illustrates the conductive members 93 and blank-off plates 99 in a position that is partially removed from the processing region 15 of the process chamber 10.

Figure 10A is an isometric cross-sectional view of the process chamber 10 that illustrates an embodiment of the conductive member 93 that is formed from a plurality of overlapping sections 93C. The overlapping sections 93C are adapted to allow the removal of the conductive member 93 from the processing region 15 without the conductive member 93 excessively intruding into areas outside and adjacent to the process chamber 10. This embodiment thus reduces the required space needed to perform maintenance activities on the process chamber 10, since it can prevent or minimize the interference between the conductive member 93 and other processing chambers on a cluster tool (not shown) that contains the processing chamber 10 or walls of the space in which the processing chamber 10 and cluster tool are installed. In one embodiment, the conductive member 93 is formed from a plurality of overlapping sections 93C which are pivotally attached to each other so that all overlapping sections 93C of the conductive member 93 can be easily removed and positioned in the processing region 15 as one complete unit. In one aspect, each of the overlapping sections 93C overlap such that a minimal gap is formed between them. The minimal gap is generally designed to limit the amount of deposited material during processing that can or will not make its way through the minimal gap to the conductive members support 97, which the overlapping sections 93C rest on.

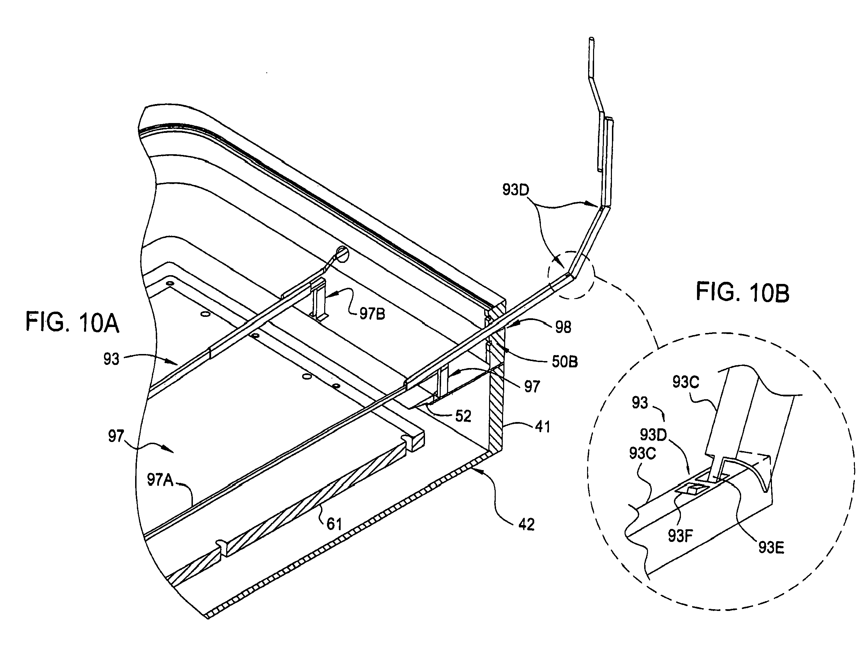

Figure 10A illustrates one embodiment that has three overlapping sections 93C that are pivotally attached to each other at the connection joints 93D. Figure 10B illustrates a close-up view of one of the connection joints 93D shown in Figure 10A. In one embodiment, as shown in Figure 10B, adjacent overlapping sections 93C are coupled to each other at the connection joints 93D by use of an protruding arm section 93E of one overlapping section 93C that is connectively engaged with a post member 93F formed in another overlapping section 93C. In this configuration the overlapping sections 93C can be linked together and positioned as a group. In one aspect, it may be desirable to individually attach and position each of the overlapping sections 93C one at a time. In one aspect, the connection joints 93D can be configured such that each of the overlapping sections 93C may be attached or detached from each other by orienting the overlapping sections 93C such that the protruding arm section 93E engage or disengage the post member 93F of the other overlapping section 93C. The connection joint design 93D illustrates one possible way in which the overlapping sections 93C can be coupled together, other and further embodiments of the invention may be devised without departing from the basic scope thereof.

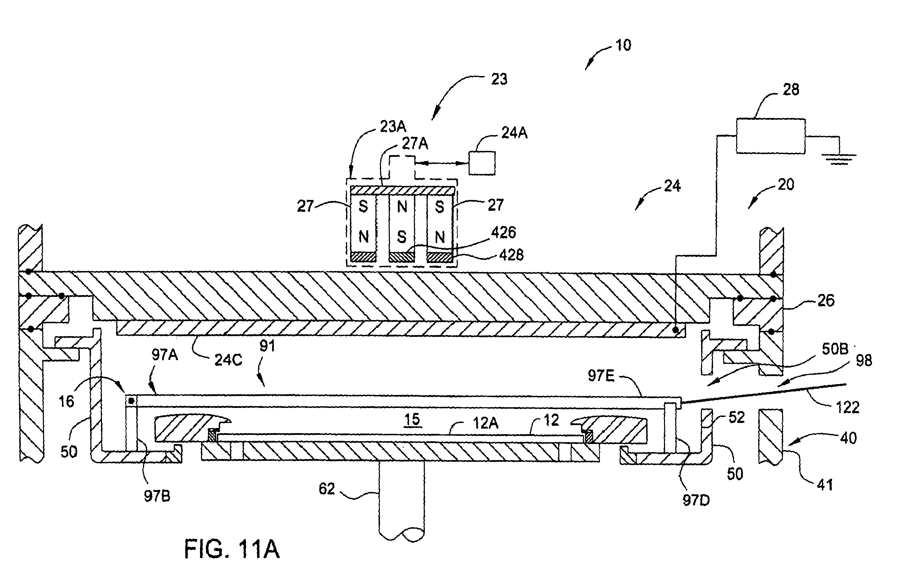

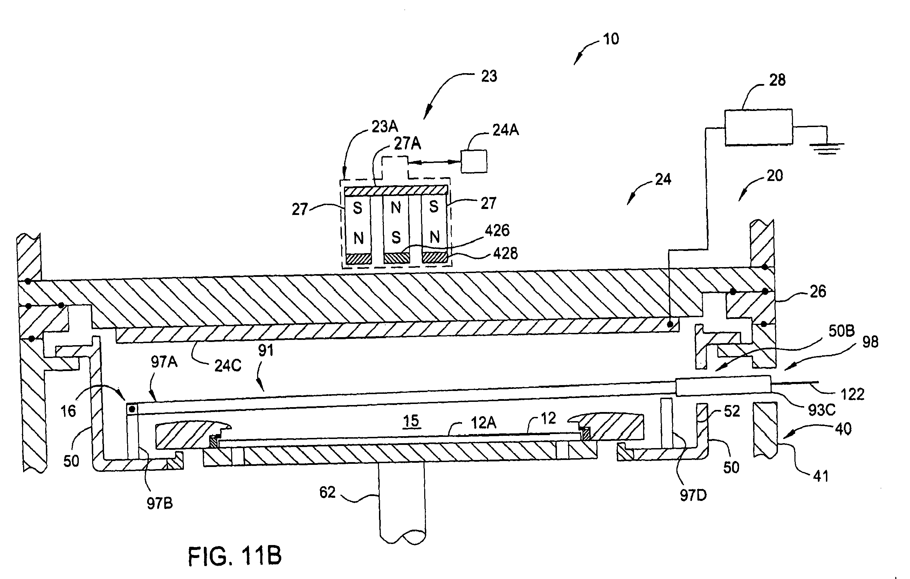

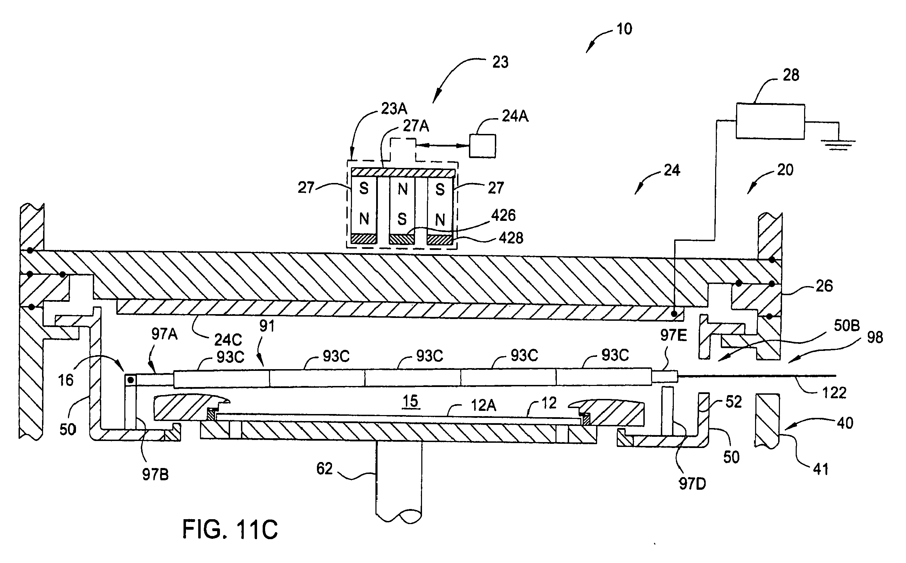

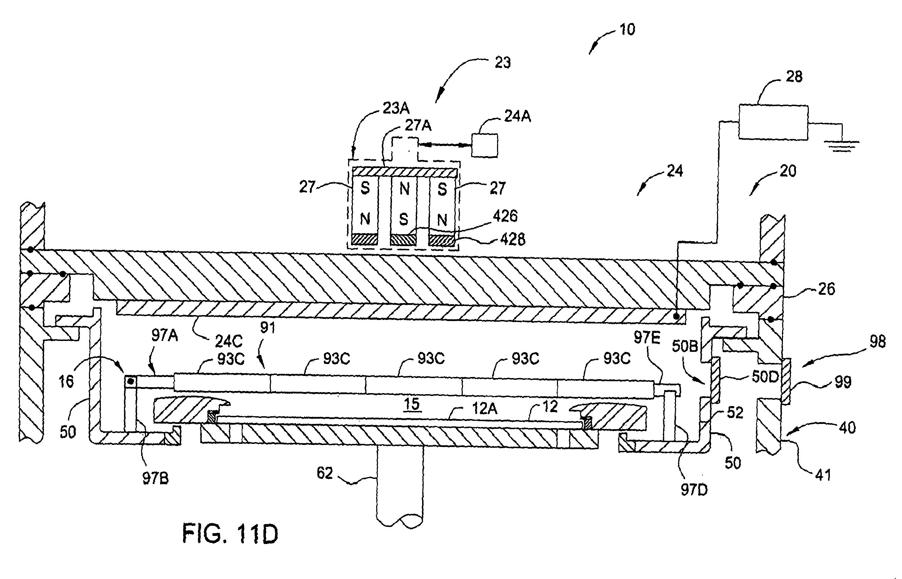

Figures 11A-11 D are side cross-sectional views of one embodiment of the process chamber 10 that illustrate the overlapping sections 93C in various stages of insertion into the processing region 15 through the access hole 50B formed in the shield 50 and the access port 98 formed in the chamber wall 41. The configuration and steps illustrated in Figures 11 A-11 D may be especially useful where the overlapping sections 93C have a cross-section that is similar to the conductive member 93 cross-section shown in Figure 6B. In Figure 11A the horizontal support 97A is illustrated in its "processing position" in which the horizontal support 97A is generally horizontal and is in physical and electrical contact with a saddle support 97D. The saddle support 97D is generally a block that has a u-shaped feature formed at one end that is adapted to contact the engaged end 97E of the horizontal support 97A. In Figure 11A the outer surface of the horizontal support 97A is directly exposed to the processing region 15. One will note that Figure 11 A illustrates a case where a tool 122 has been inserted through the access hole 50B and the access port 98 so that it can engage with the engaged end 97E of the horizontal support 97A and raise the engaged end 97E (see Figure 11B) relative to a pivot point 16 positioned at the other end of the horizontal support 97A. Figure 11B illustrates the horizontal support 97A in a raised position such that an overlapping section 93C can be slid over the tool 122, the engaged end 97E and onto to the horizontal support 97A. Figure 11C illustrates the horizontal support 97A in a raised position in a state where a plurality of overlapping sections 93C have been positioned over and cover the horizontal support 97A. Referring to Figure 11 D, after the overlapping sections 93C have been positioned over and cover the horizontal support 97A, the engaged end 97E of the horizontal support 97A can be placed back into its "processing position" in which the engaged end 97E is brought into contact with the saddle support 97D. In one aspect, the overlapping sections 93 can be removed from the processing region 15 following the steps shown in Figures 11A-11 D in reverse.

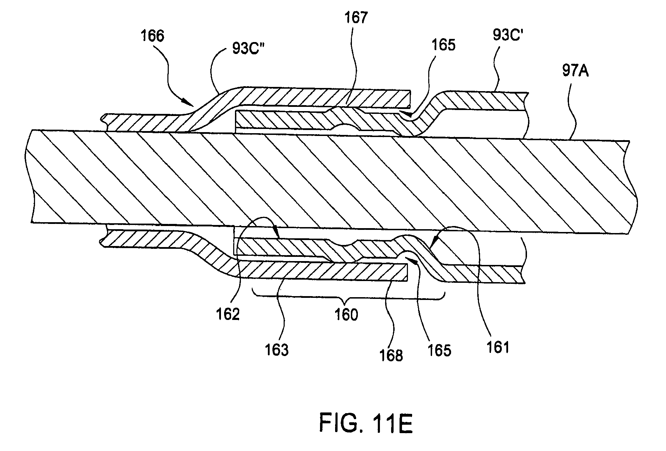

Figure 11E is a side cross-sectional view of two overlapping sections (elements 93C' and 93C") that have a cross-section similar to the configuration shown in Figure 6B. In this embodiment, the overlapping sections 93C are connected to each other at a connection region 160 so that they can be easily inserted on and removed from the horizontal support 97A found in the processing region 15 of the process chamber 10. This configuration may be useful when the overlapping sections 93C are inserted and/or removed form the processing region 15 using the steps illustrated in Figures 11A-11 D. The connection region 160 generally contains a male section 162 found in a first overlapping section 93C', a hard stop region 166 found in the second overlapping section 93C", and a female section 163 that extends from a hard stop region 166 to the end 168 of the second overlapping section 93C". In one embodiment, the connection region 160 also contains a shadowed feature 161 found in the first overlapping section 93C'. In one aspect, the length of the male section 162, the length of the female section 163 and the position and shape of the shadowed feature 161 are sized such that deposition (not shown) which lands on the outer surface of the overlapping sections (elements 93C' and 93C") will not form a "deposited material bridge" connecting the overlapping sections. Forming a material bridge may generate particles due to the stress induced in the deposited material due to the thermal expansion and contraction of the overlapping sections created by the heating and cooling of the overlapping sections during deposition processing and process chamber idle times. In general the shadowed feature 161 is a concave feature formed in the male section 162 of the first overlapping section 93C' that is deep enough to collect the deposited material shadowed by the end 168 of the second overlapping section 93C" and is long enough so that the deposited material will not make its way to the interface 165 formed between the male section 162 and the female section 163 and form a "deposited material bridge". In one aspect, an engaging feature 167 is formed in the male section 162 (shown in Figure 11 D), or the female section 163, to create a region that positively engages (e.g., location or interference fit) with the other overlapping section 93C to allow successive overlapping sections 93C to be more easily inserted and removed as a group from the processing region 15. In general the features illustrated in Figure 11 D can be formed by conventional metal working or machining techniques.

### Automated Removal of the Anode Assembly Components

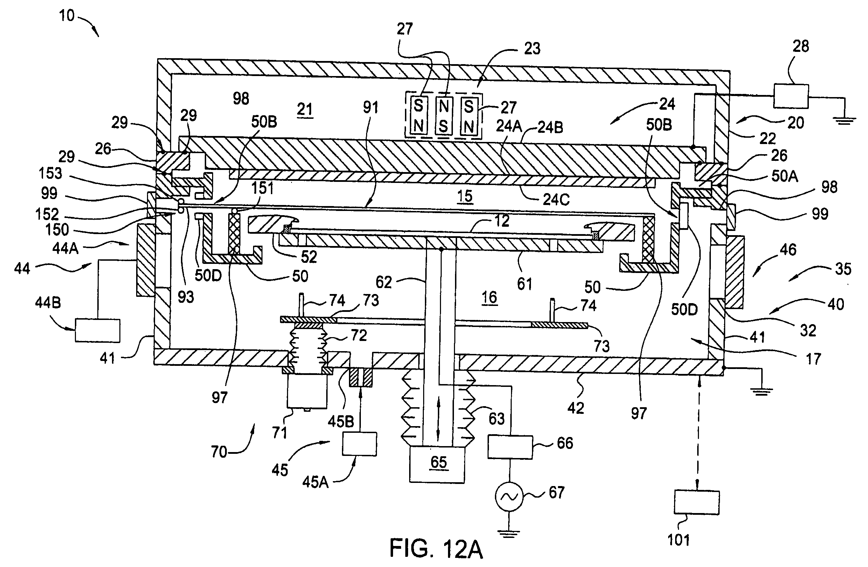

In one embodiment, as shown in Figure 12A, the anode assembly 91 is adapted to facilitate the removal of a conductive member 93 that has been deposited in the processing region 15 by allowing a motion assembly 150 to feed the deposited on conductive member 93 through a access hole 50B formed in the shield 50 and the access port 98 formed in the chamber wall 41 of the process chamber 10. In reverse the motion assembly 150 is adapted to feed a conductive member 93 into the process chamber 10 so that it will rest on and cover the conductive member support 97. The motion assembly 150 generally contains a first guide roller 151, a second guide roller 153 and drive roller 152 that are adapted to guide and position the conductive member 93 as it is removed from or placed in the process chamber 10. In one aspect, the conductive member 93 remains in contact with the second guide roller 153 and the drive roller 152 when the conductive member 93 is properly positioned in the processing region 15. In this configuration the drive roller 152, which is connected to an actuator (not shown), is adapted to transfer a conductive member 93 from its position on the conductive member support 97 through the access hole 50B and the access port 98 and out of the process chamber 10. During the conductive member 93 removal process the drive roller 152 and the guide roller 153 have the primary task of causing the conductive member 93 to move from its position on the conductive member support 97 to a position outside of the process chamber 10. During the conductive member 93 insertion process the drive roller 152 and the guide roller 153 have the primary task of causing the conductive member 93 to be moved from a position outside of the process chamber 10 to a desired position on the conductive member support 97.

In one aspect, the first guide roller 151 is coupled to an actuator (not shown) so that it can transfer the conductive member 93 to the second guide roller 153 and the drive roller 152. In this configuration the conductive member 93 can be transferred from the process chamber 10 by cooperative motion of the drive roller 152 and the first guide roller 151.

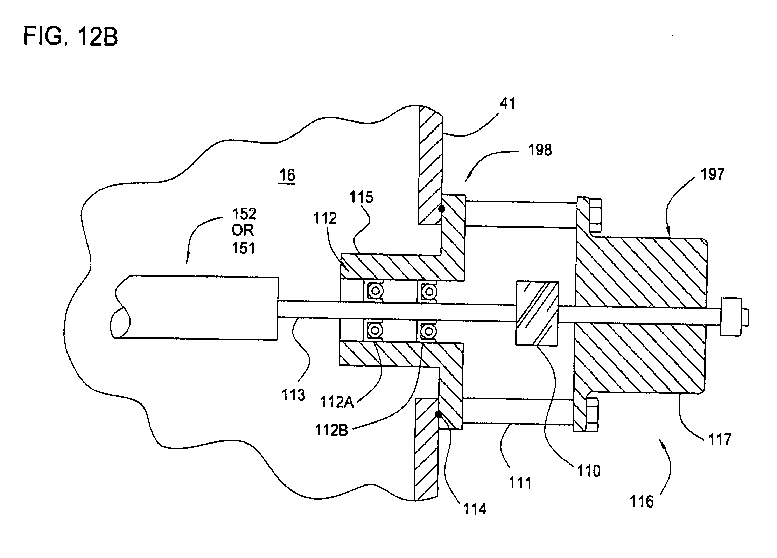

Figure 12B illustrates a cross-sectional view of one embodiment of a motion control assembly 116 that is adapted to rotate the drive roller 152, and/or first guide roller 151, to adjust the position of the conductive member 93 as it passes through the processing region 15, access hole 50B and the access port 198. In general the motion control assembly 116 contains a seal assembly 198 and a motor assembly 197. The seal assembly 198 generally contains a shaft 113 coupled to the motor assembly 197 and drive roller 152 (or first guide roller 151), a mounting plate 115 and at least one seal 112. The motor assembly 197 generally contains an actuator 117, a mounting bracket 111 that is used to attach the actuator 117 to the seal assembly 198, and a motor coupling 110 that attached the actuator 117 to the shaft 113. In this configuration the rotational motion of the motor assembly 197 is translated to the drive roller 152 (or first guide roller 151) and is passed from outside the chamber wall 41 to a position inside the lower vacuum region 16 where it connects to the drive roller 152 (or first guide roller 151). In one aspect, as shown in Figure 12B, the seal 112 comprises two lip seals (elements 112A and 112B) that are adapted to allow rotation of the shaft 113 and prevent leakage of atmospheric contaminants into the processing chamber. In one aspect it may be necessary to differentially pump (not shown) the region between the two seals to reduce the pressure drop across a single seal (elements 112A or 112B). In one aspect of the invention the seal 112 is a conventional ferrofluidic seal (e.g., purchased from Schoonover, Inc. of Canton, Georgia) or magnetically coupled rotational feedthrough which are well known in the art for passing rotational motion to a part in a vacuum environment. Therefore, by use of the seal 112 and a o-ring seal 114 formed between the plate 115 and the chamber wall 41 the atmospheric contaminants can be kept from the lower vacuum region 16 and the processing region 15. In one aspect, the drive roller 152 and the guide roller 153 may be driven by a DC servo motor or stepper motor that are coupled to the rollers, which are well known in the art.

### Shield and Anode Assembly Bias

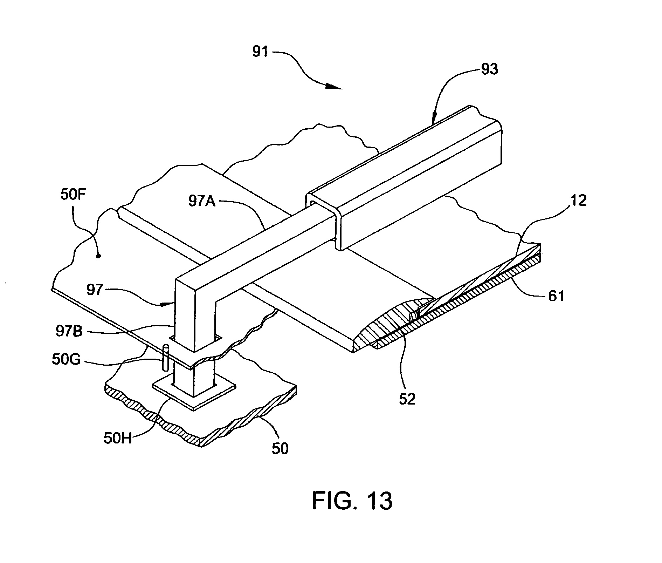

In one embodiment of the process chamber 10, a biasable shield 50F may be positioned in the processing region to change the electric field and the plasma density generated near the edge of the target and substrate. Figure 13 illustrates one embodiment of the biasable shield 50F that is positioned around the periphery of the substrate 12 and is electrically connected to the shield 50, which is grounded, by use of an electrical component 50G. In one aspect, the electrical component 50G may be used as a "stand-off" to physically space the biasable shield 50F from the shield 50. It should be noted that the term "grounded" is generally intended to describe a direct or in-direct electrical connection between a component and the anode. The biasable shield 50F may be purposely biased at a different potential versus the anode surfaces due to the introduction of the electrical component 50G that may add resistive, capacitive and/or inductive type elements to the electrical path between the biasable shield 50F and the anode surfaces. In one aspect, during processing a bias voltage, which will generally be less anodic, may be "passively" induced in the biasable shield 50F due to a bias applied between the target and anodic surface (e.g., shield 50) and the interaction of the biasable shield 50F with the plasma generated in the processing region. In another aspect, not shown, the biasable shield 50F may be separately biased by use of a power supply (not shown) which is in electrical communication with the biasable shield 50F and the anode surfaces. In this configuration the electrical component 50G may act as an insulator.

In another embodiment of the processing chamber 10, the anode assembly 91 may be purposely biased at a different potential versus the anode surfaces by the introduction of a resistive, capacitive and/or inductive components to the electrical path between the anode assembly 91 and the anode surfaces. In one embodiment, as shown in Figure 13, a second electrical component 50H may be positioned in the electrical path between the anode assembly 91 and the shield 50 to allow the anode assembly 91 to be biased at a different potential than the shield 50. In one aspect, during processing a bias voltage, which will generally be less anodic, may be "passively" induced in the anode assembly 91 due to a bias applied between the target and anodic surface (e.g., shield 50) and the interaction of the anode assembly 91 with the plasma generated in the processing region. In another aspect, not shown, the anode assembly 91 may be separately biased by use of a power supply (not shown) which is in electrical communication with the anode assembly 91 and the anode surfaces. In this configuration the second electrical component 50H may act as an insulator.

While the foregoing is directed to embodiments of the present invention, other and further embodiments of the invention may be devised without departing from the basic scope thereof, and the scope thereof is determined by the claims that follow.

## Claims

1. A plasma processing chamber assembly for depositing a layer on a substrate (12) comprising:
a plasma processing chamber (10) having a processing region (15);
a target (24) positioned on the plasma processing chamber (10) so that a surface (24c) of the target is in contact with the processing region (15);
a substrate support (5) positioned within the plasma processing chamber (10) and having a substrate receiving surface, wherein a surface of a substrate (12) positioned on the substrate receiving surface is in contact with the processing region (15); and
a plurality of anodic members (91) positioned in the processing region (15) between the target (24) and the substrate support (5), wherein the plurality of anodic members are in electrical communication with an anodic shield (50) that is in contact with the processing region (15).

2. The plasma processing chamber assembly of claim 1, wherein each of the plurality of anodic members (91) further comprise:
a first anodic member mounted inside the processing region (15) and a second anodic member positioned on the first member, wherein the second anodic member is in electrical communication with the first anodic member.

3. The plasma processing chamber assembly of claim 1 or 2, wherein the surface area of the surface of the substrate (12) that is in contact with the processing region is at least 19,500 cm².

4. The plasma processing chamber assembly according to any one of the claims 1 - 3, wherein the plurality of anodic members further comprise at least two anodic members that are positioned inside the processing region and are in electrical communication with the anodic shield (50).

5. The plasma processing chamber assembly according to any one of the claims 1 - 4, further comprising:
a magnetron assembly (23) having a first pole (261) and a second pole (262) that are magnetically coupled to the processing region (15) through the target (24),
wherein at least one region of the first and second poles are aligned relative to the anodic members.

6. The plasma processing chamber assembly according to any one of the claims 1 - 5, further comprising:
a magnetron assembly (23) having a first pole (261) and a second pole (262) that are magnetically coupled to the processing region through the target (24), wherein the first pole and second pole are configured to form a plasma loop that has a serpentine shape.

7. The plasma processing chamber assembly according to any one of the claims 1-6, wherein the plurality of anodic members further comprise:
a first member mounted inside the processing region (15), wherein the first member is connected to the anodic shield (50); and
a second member positioned on the first member, wherein the second member is in electrical communication with the first member and is adapted to cover at least a portion of the first member to prevent deposition from depositing on the first member.

8. The plasma processing chamber assembly according to any one of the claims 1 - 7, wherein one or more of the plurality of anodic members further comprises:
a conductive member (93) positioned inside the processing region, wherein the conductive member comprises:
two or more sections that are connected to each other and are in electrical communication with the anodic shield (50).

9. The plasma processing chamber assembly according to any one of the claims 1 - 8, further comprising:
one or more anodic members that are positioned inside the processing region, wherein each of the at least two anodic members comprise:
a first member mounted inside the processing region, wherein the first member is in electrical communication with the anodic shield; and
a second member positioned on the first member, wherein the second member is in electrical communication with the first member; and
a motion assembly that is adapted to position the second member relative to the first member.

10. The plasma processing chamber assembly according to any one of the claims 1-9, further comprising:
a biasable shield (50F) that is positioned within the processing region, wherein the biasable shield (50F) is adapted to be biased at a potential that is different than the anodic shield.

11. A plasma processing chamber assembly for uniformly depositing a layer on a rectangular substrate comprising:
a plasma processing chamber (10) having a processing region;
a target (24) positioned on the plasma processing chamber (10) so that a surface of the target (24C) is in contact with the processing region (15);
a substrate support (5) positioned within the plasma processing chamber (10) and having a substrate receiving surface, wherein a surface of a rectangular substrate positioned on the substrate receiving surface is in contact with the processing region (15); and
a plurality of anodic members positioned within the processing region (15) between the target (24) and the substrate support (5), wherein the plurality of anodic members are in electrical communication with an anodic shield (50) and are aligned in a direction relative to an edge of the rectangular substrate.

12. The plasma processing chamber assembly of claim 11, wherein the surface area of the surface of the rectangular substrate is at least 19,500 cm².

13. The plasma processing chamber assembly of claim 11 or 12, wherein the plurality of anodic members are aligned in a direction that is generally parallel to an edge of the rectangular substrate.

14. The plasma processing chamber assembly according to any one of the claims 11 - 13, wherein the plurality of anodic members are generally bar shaped and are aligned along a first direction, wherein the first direction is aligned in a direction that is generally parallel to an edge of the rectangular substrate.

15. A plasma processing chamber assembly for depositing a layer on a substrate comprising:
a chamber body assembly (40) having one or more walls that enclose a vacuum region (16), wherein the chamber body assembly has one or more access ports (32) formed in at least one of the one or more walls;
a target (24) positioned on the chamber body assembly (40) so that a surface of the target faces (24C) a processing region formed within the vacuum region (16);
an anodic shield (50) having a surface that contacts the vacuum region (16), wherein the anodic shield comprises:
one or more walls (41) that partially enclose the processing region; and
a first slot formed through the one of the one or more walls of the anodic shield;
a substrate support (61) positioned within the vacuum region (16) and having a substrate receiving surface, wherein a processing surface of a substrate positioned on the substrate receiving surface faces the target (24); and
one or more anodic members that comprise a first member mounted within the processing region, wherein the first member is in electrical communication with the anodic shield (50) and is adapted to be removed from the processing region through the first slot and one of the one or more access ports.

16. The plasma processing chamber assembly of claim 15, further comprising a second member on which the first member is positioned, wherein the second member is in electrical communication with the first member and the anodic shield.

17. The plasma processing chamber assembly of claim 15 or 16, wherein the surface area of the processing surface of the substrate that is in contact with the processing region (15) is at least 19,500 cm².

18. The plasma processing chamber assembly according to any one of the claims 15 - 17, wherein the one or more anodic members further comprise at least 2 anodic members and not more than 20 anodic members that are positioned inside the processing region (15).

19. The plasma processing chamber assembly according to any one of the claims 15-18, further comprising:
a magnetron assembly (23) having a first pole (261) and a second pole (262) that are magnetically coupled to the processing region (15) through the target (24), wherein at least one region of the first and second poles are aligned relative to a surface of the one or more anodic members.

20. The plasma processing chamber assembly according to any one of the claims 15-19, further comprising:
a magnetron assembly (23) having a first pole (261) and a second pole (262) that are magnetically coupled to the processing region through the target (24), wherein the first pole (261) and second pole (262) are configured to form a serpentine shape.

21. The plasma processing chamber assembly according to any one of the claims 15-20, wherein each of the one or more anodic members further comprise:
a conductive member (93) positioned inside the processing region (15), wherein the conductive member comprises:
two or more sections that are connected to each other and are in electrical communication with the anodic shield.

22. An anode member positioned in a plasma processing chamber assembly, wherein the anode member comprises:
a first member mounted between a target (24) and a substrate (12) positioned on a substrate support (5), wherein the first member is in electrical communication with an anodic pole of a power supply that is adapted to cathodically bias the target; and
a plurality of second members positioned on the first member, wherein the second members are in electrical communication with the first member and are adapted to cover at least a portion of the first member to prevent sputtered material from the target depositing on the first member.

23. The anode member of claim 22, wherein at least two of the plurality of second members are pivotally connected together.

24. A method of sputter depositing a layer on a substrate, comprising:
depositing a layer on a substrate surface in a sputter deposition chamber that has one or more walls and a target (24) that enclose a processing region (15) and one or more anodic members positioned within the processing region;
venting the sputter deposition chamber by injecting a gas into the processing region; and
removing one of the one or more anodic members from the processing region through an access hole formed in one of the one or more walls of the sputter deposition chamber.

25. The method of claim 24, further comprising:
flowing a gas into the processing region while removing one of the one or more conductive member from the processing region, wherein the flow of gas is adapted to minimize the amount of atmospheric contamination entering the processing region through the access hole.

26. A method of enhancing the uniformity of a sputter deposition process on a substrate, comprising:
providing a sputter deposition chamber that has one or more walls that form a processing region, a target, and two or more anode assemblies positioned below the target and within the processing region, wherein the two or more anode assemblies are in electrical communication with an anodic surface positioned within the processing region; and
depositing a layer on a surface of a substrate positioned in the processing region by cathodically biasing the target relative to the two or more anode assemblies and the anodic surface using a power supply.

27. The method of claim 26, wherein the two or more anode assemblies are bar shaped.

28. The method of claim 27, further comprising:
providing a magnetron assembly that has a first pole and a second pole that are magnetically coupled to the processing region through the target, wherein the depositing a layer on a surface of a substrate further comprises:
moving the magnetron assembly relative to a surface of the target and the two or more anode assemblies, wherein at least one region of the first and second poles remain generally aligned relative to a long direction of the one or more anodic members as the magnetron assembly is moving.

29. The method of claim 28, wherein the first pole and second pole of the magnetron assembly are configured to form a serpentine shape.

30. The method according to any one of the claims 26 - 29, wherein providing two or more anode assemblies further comprises:
aligning a surface of at least one of the two or more anode assemblies with a surface of a rectangular substrate positioned on a substrate support that is positioned in the processing region.

31. The method according to any one of the claims 26 - 30, wherein the surface area of the processing surface of the substrate is at least 19,500 cm².

32. A method of enhancing the uniformity of a sputter deposition process on a substrate, comprising:
positioning an anode member in a processing region formed between a target and a processing surface of a substrate positioned on a substrate support, wherein positioning the anode member comprises:
positioning a first member in the processing region, wherein the first member is in electrical communication with an anodic shield; and
positioning one or more second members on the first member, wherein the one or more second members are in electrical communication with the first member and are adapted to cover at least a portion of the first member to prevent sputtered material from the target depositing on the first member; and
depositing a layer on the processing surface of the substrate by applying a bias between the target and the anodic shield.

33. The method of claim 32, further comprising:
positioning a magnetron assembly that has a first pole and a second pole that are magnetically coupled to the processing region through the target and aligning at least one region of the first and second poles relative to the anodic members.

34. The method of claim 32 or 33, wherein positioning a first member in the processing region further comprises:
aligning a surface of the first member relative to a surface of a rectangular shaped substrate positioned on the substrate support.

35. The method according to any one of the claims 32 - 34, further comprises:
removing one of the one or more of the second members from the processing region through an access hole formed in a wall of the sputter deposition chamber after sputter depositing a layer of material on the second member.

36. A plasma processing chamber assembly for uniformly depositing a layer on a rectangular substrate comprising:
a plasma processing chamber having a processing region;
a target positioned on the plasma processing chamber so that a surface of the target is in contact with the processing region;
a substrate support positioned within the plasma processing chamber and having a substrate receiving surface, wherein a surface of a rectangular substrate positioned on the substrate receiving surface is in contact with the processing region; and
a plurality of anodic members positioned within the processing region between the target and the substrate support, wherein the plurality of anodic members comprise:
two or more first members mounted inside the processing region, wherein each of the two or more first members are in electrical communication with an anodic shield and are aligned in a direction relative to an edge of the rectangular substrate; and
one or more second members that are positioned on one of the one or more first members, wherein the second member is in electrical communication with the one first member.

37. The plasma processing chamber assembly of claim 36, wherein the two or more first members further comprise at least 2 anodic members and not more than 20 anodic members.

38. The plasma processing chamber assembly according to claim 36 or 37, further comprising:
a magnetron assembly having a first pole and a second pole that are magnetically coupled to the processing region through the target, wherein at least one region of the first and second poles are aligned relative to a surface of the two or more first members.

39. The plasma processing chamber assembly according to any one of the claims 36 - 38, wherein the one or more first members are generally bar shaped and are aligned along a first direction, wherein the first direction is aligned in a direction that is generally parallel to an edge of the rectangular substrate.

40. The plasma processing chamber assembly according to any one of the claims 36 - 39, wherein the plurality of anodic members further comprise a electrical connector that is positioned between a first member and a second member, wherein the electrical connector is adapted to improve the electrical contact between the first member and the second member.
